# EUROPEAN PATENT APPLICATION

(11) **EP 4 753 412 A1**
(43) Date of publication of application: **03.06.2026**
(21) Application number: 25217703.5
(22) Date of filing: 21.11.2025
(51) Int. Cl.: H10H 20/815, H10H 20/83, H10H 20/852

(54) **LIGHT EMITTING DEVICE AND DISPLAY APPARATUS INCLUDING THE SAME**

(30) Priority: 27.11.2024 KR 20240172765
(71) Applicant: Samsung Electronics Co., Ltd., Suwon-si, Gyeonggi-do 16677 (KR)
(72) Inventor: YOO, Chuljong, 16677 Suwon-si (KR); KANG, Jonghyuk, 16677 Suwon-si (KR); KIM, Seulki, 16677 Suwon-si (KR); RYU, Yongwoo, 16677 Suwon-si (KR); YEO, Soyoung, 16677 Suwon-si (KR); JUNG, Jaehoon, 16677 Suwon-si (KR); CHA, Hyungrae, 16677 Suwon-si (KR); HAN, Kookhyun, 16677 Suwon-si (KR)
(74) Representative: Marks & Clerk LLP

(57) **Abstract**

A light emitting device includes a light emitting structure, a first conductivity-type base layer, a transparent electrode layer, a reflective electrode layer contacting the transparent electrode layer and extending in a horizontal direction, an upper insulating layer surrounding the first conductivity-type base layer, a first contact electrode conformally disposed on an upper surface of the first conductivity-type base layer, and a second contact electrode penetrating the upper insulating layer and contacting the reflective electrode layer. A vertical level of each of uppermost surfaces of the first and second contact electrodes is higher than a vertical level of an uppermost surface of the first conductivity-type base layer, and a vertical level of a lowermost surface of the second contact electrode is lower than a vertical level of a lowermost surface of the first conductivity-type base layer.

## Description

### BACKGROUND

The present disclosure relates to a light emitting device and a display apparatus including the same, and more particularly, to a light emitting device having excellent light extraction efficiency and a display apparatus including the same.

Light emitting devices, light sources that convert electrical energy into optical energy, have been widely used as light sources for various display apparatuses, such as lighting devices, TVs, mobile phones, PCs, laptops, personal digital assistants (PDAs), digital cameras, camcorders, viewfinders, microdisplays, 3D displays, augmented reality displays, and smart watches. Recently, micro-scale or nano-scale ultra-small light emitting devices using compound semiconductors have been developed, and there is a need to develop light emitting devices with a new structure to improve light extraction efficiency in these ultra-small light emitting devices.

### SUMMARY

It is an aspect to provide a light emitting device having a structure with improved light extraction efficiency and a display apparatus including the light emitting device.

According to an aspect of one or more embodiments, there is provided a light emitting device comprising a light emitting structure including a first conductivity-type semiconductor layer, an active layer, and a second conductivity-type semiconductor layer in a vertical direction from top to bottom; a first conductivity-type base layer located on the light emitting structure; a transparent electrode layer below the second conductivity-type semiconductor layer and covering the second conductivity-type semiconductor layer; a reflective electrode layer contacting the transparent electrode layer and extending in a horizontal direction; an upper insulating layer surrounding the first conductivity-type base layer; a first contact electrode conformally disposed on an upper surface of the first conductivity-type base layer; and a second contact electrode penetrating the upper insulating layer and contacting the reflective electrode layer. A vertical level of each of uppermost surfaces of the first contact electrode and the second contact electrode is higher in the vertical direction than a vertical level of an uppermost surface of the first conductivity-type base layer in the vertical direction, and a vertical level of a lowermost surface of the second contact electrode in the vertical direction is lower than a vertical level of a lowermost surface of the first conductivity-type base layer in the vertical direction.

According to another aspect of one or more embodiments, there is provided a light emitting device comprising a light emitting structure including a first conductivity-type semiconductor layer, an active layer, and a second conductivity-type semiconductor layer in a vertical direction from top to bottom; a first conductivity-type base layer on the light emitting structure; a transparent electrode layer below the second conductivity-type semiconductor layer and covering the second conductivity-type semiconductor layer; a first reflective electrode layer contacting a lower surface of the first conductivity-type base layer and extending in a horizontal direction; a second reflective electrode layer contacting a lower surface of the transparent electrode layer and extending in the horizontal direction; an upper insulating layer surrounding the first conductivity-type base layer; a first contact electrode penetrating the upper insulating layer and contacting the first reflective electrode layer; and a second contact electrode penetrating the upper insulating layer and contacting the second reflective electrode layer. A vertical level of each of uppermost surfaces of the first contact electrode and the second contact electrode in the vertical direction is higher than a vertical level of an uppermost surface of the first conductivity-type base layer in the vertical direction, and a vertical level of each of lowermost surfaces of the first contact electrode and the second contact electrode in the vertical direction is equal to or lower than a vertical level of a lowermost surface of the first conductivity-type base layer in the vertical direction.

According to yet another aspect of one or more embodiments, there is provided a display apparatus comprising a driving circuit board including an interconnection line and a transistor; and a light emitting device disposed on the driving circuit board. The light emitting device includes a light emitting structure including a first conductivity-type semiconductor layer, an active layer, and a second conductivity-type semiconductor layer in a vertical direction from top to bottom; a first conductivity-type base layer on the light emitting structure; a transparent electrode layer below the second conductivity-type semiconductor layer and covering the second conductivity-type semiconductor layer; a reflective electrode layer contacting the transparent electrode layer and extending in a horizontal direction; an upper insulating layer surrounding the first conductivity-type base layer; a first contact electrode conformally disposed on an upper surface of the first conductivity-type base layer; and a second contact electrode penetrating the upper insulating layer and contacting the reflective electrode layer. A vertical level of each of uppermost surfaces of the first contact electrode and the second contact electrode in the vertical direction is higher than a vertical level of an uppermost surface of the first conductivity-type base layer in the vertical direction, a vertical level of a lowermost surface of the second contact electrode in the vertical direction is lower than a vertical level of a lowermost surface of the first conductivity-type base layer in the vertical direction, and the second contact electrode is connected to the transistor through the interconnection line.

According to still yet another aspect of one or more embodiments, there is provided a display apparatus comprising a driving circuit board including an interconnection line and a transistor; and a light emitting device disposed on the driving circuit board. The light emitting device includes a light emitting structure including a first conductivity-type semiconductor layer, an active layer, and a second conductivity-type semiconductor layer in a vertical direction from top to bottom; a first conductivity-type base layer on the light emitting structure; a transparent electrode layer below the second conductivity-type semiconductor layer and covering the second conductivity-type semiconductor layer; a first reflective electrode layer contacting a lower surface of the first conductivity-type base layer and extending in a horizontal direction; a second reflective electrode layer contacting a lower surface of the transparent electrode layer and extending in the horizontal direction; an upper insulating layer surrounding the first conductivity-type base layer; a first contact electrode penetrating the upper insulating layer and contacting the first reflective electrode layer; and a second contact electrode penetrating the upper insulating layer and contacting the second reflective electrode layer. A vertical level of each of uppermost surfaces of the first contact electrode and the second contact electrode in the vertical direction is higher than a vertical level of an uppermost surface of the first conductivity-type base layer in the vertical direction, a vertical level of each of lowermost surfaces of the first contact electrode and the second contact electrode in the vertical direction is equal to or lower than a vertical level of a lowermost surface of the first conductivity-type base layer in the vertical direction, and the second contact electrode is connected to the transistor through the interconnection line.

The first conductivity-type semiconductor layer, active layer, and second conductivity-type semiconductor layer may be stacked in a vertical direction from top to bottom. The first conductivity-type base layer may be located on the light emitting structure in a vertical direction. The first conductivity-type base layer may overlay at least a portion of the light emitting structure. The transparent electrode layer may overlay at least a portion, including all of, the second conductivity-type semiconductor layer in a vertical direction, e.g., from top to bottom. A vertical level of each uppermost surface of the first contact electrode and the second contact electrode may be higher in the vertical direction than a vertical level of an uppermost surface of the first conductivity-type base layer in a vertical direction (e.g., from bottom to top). The upper insulating layer may surround a side surface of the first conductivity-type base layer.

The first contact electrode and the second contact electrode may be formed in the same manufacturing process. The first contact electrode and the second contact electrode may extend (or be formed) in the same direction, i.e., the vertical direction. The electrodes may extend in a direction of a light emitting surface. The light emitting surface may be the uppermost surface of the first conductivity-type base layer.

At least some of the above and other features of the disclosure are set out in the claims.

### BRIEF DESCRIPTION OF THE DRAWINGS

Various embodiments are more clearly understood from the following detailed description taken in conjunction with the accompanying drawings, in which:
FIG. 1 is a plan view illustrating a light emitting device according to an embodiment;
FIG. 2 is a cross-sectional view taken along line A-A' of FIG. 1;
FIG. 3 is a cross-sectional view taken along line B-B' of FIG. 1;
FIGS. 4 to 9 are diagrams illustrating light emitting devices according to some embodiments;
FIG. 10 is a cross-sectional view illustrating a display apparatus according to an embodiment;
FIGS. 11 to 20 are cross-sectional views illustrating a sequential process of a method of manufacturing a light emitting device according to an embodiment;
FIGS. 21 to 32 are cross-sectional views illustrating a sequential process of a method of manufacturing light emitting devices according to some embodiments;
FIG. 33 is a block diagram of an electronic device including a light emitting device or a display apparatus according to an embodiment;
FIG. 34 is a diagram illustrating a wearable device as an electronic device including a light emitting device or a display apparatus according to an embodiment;
FIG. 35 is a diagram illustrating augmented reality glasses as an electronic device including a light emitting device or a display apparatus according to an embodiment;
FIG. 36 is a diagram illustrating a mobile device as an electronic device including a light emitting device or a display apparatus according to an embodiment;
FIG. 37 is a diagram illustrating a head-up display device as an electronic device including a light emitting device or display apparatus according to an embodiment; and
FIG. 38 is a diagram illustrating a large signage as an electronic device including a light emitting device or display apparatus according to an embodiment.

### DETAILED DESCRIPTION

Hereinafter, various embodiments are described in detail with reference to the accompanying drawings.

For ease of understanding, terms, such as upper surface/lower surface, above/below, top/bottom, etc. are referred to based on directions shown in the referenced drawings. Therefore, even the same surface may be referred to differently as an upper surface and a lower surface depending on the direction shown in the drawing.

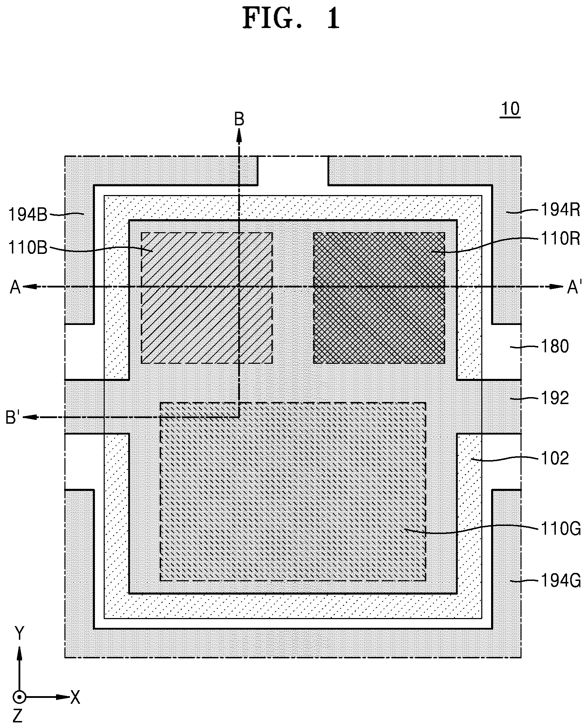

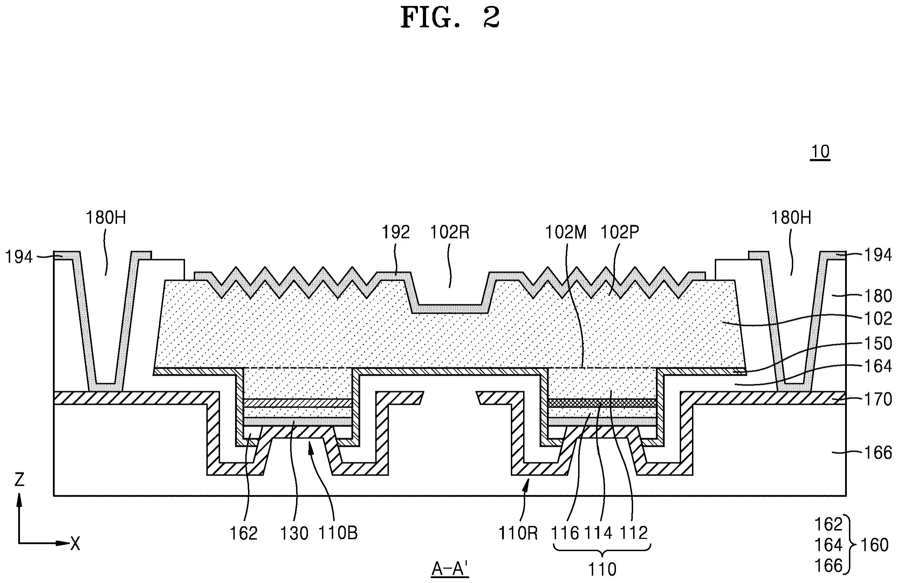

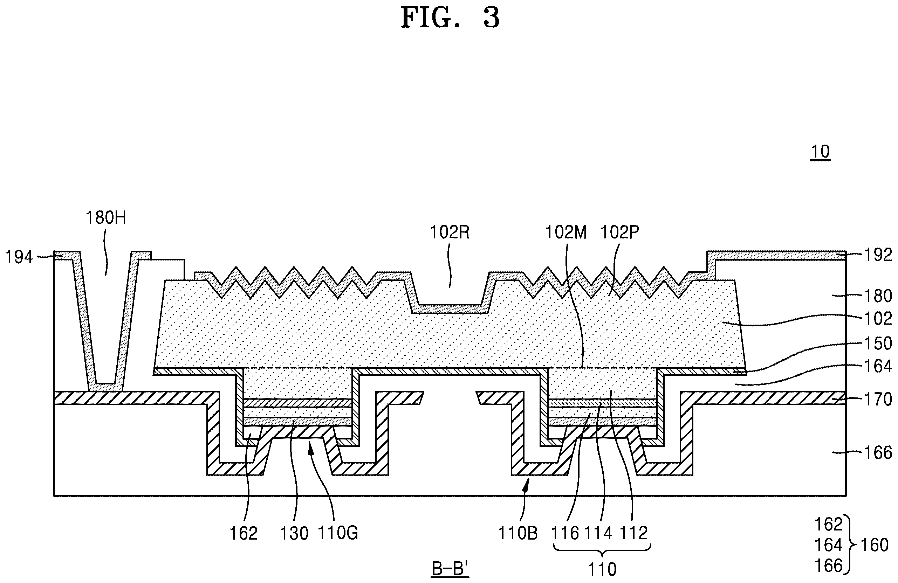

FIG. 1 is a plan view illustrating a light emitting device 10 according to an embodiment. FIG. 2 is a cross-sectional view taken along line A-A' of FIG. 1. FIG. 3 is a cross-sectional view taken along line B-B' of FIG. 1.

Referring to FIGS. 1 to 3 together, the light emitting device 10 may include a first conductivity-type base layer 102 and a plurality of light emitting structures 110 arranged below a main surface 102M of the first conductivity-type base layer 102.

The light emitting structure 110 may include a first conductivity-type semiconductor layer 112, an active layer 114, and a second conductivity-type semiconductor layer 116 sequentially stacked in a vertical direction (e.g., a Z direction in FIG. 1, the same, hereinafter) perpendicular to the main surface 102M below the main surface 102M of the first conductivity-type base layer 102.

The light emitting structure 110 may include a micro light emitting diode (LED). In some embodiments, the light emitting structure 110 may include micro-LEDs that emit at least one light selected from red, green, and blue. The term micro-LED used herein may refer to an LED having a width of about 100 µm or less in a horizontal direction (e.g., an X or Y direction in FIG. 1, the same, hereinafter).

The light emitting structure 110 may be configured to emit light having a wavelength λ. The wavelength λ may be selected within a range of about 400 nm to about 700 nm. The light emitting structure 110 may include a first light emitting structure 110R, a second light emitting structure 110G, and a third light emitting structure 110B that emit light having different wavelengths (see FIG. 1).

The first light emitting structure 110R may be configured to emit light having a first wavelength selected within a range of about 580 nm to about 700 nm. The light having the first wavelength may be red light. Herein, the wavelength range of red light may refer to the wavelength range of about 580 nm to less than about 700 nm, and there may be at least one peak of an emission spectrum in the wavelength range of red light.

The second light emitting structure 110G may be configured to emit light having a second wavelength selected within a range of about 490 nm to about 580 nm. The light having the second wavelength may be green light. Herein, the wavelength range of green light may refer to a wavelength range of about 490 nm or more and less than about 580 nm, and there may be at least one peak of an emission spectrum in the wavelength range of green light.

The third light emitting structure 110B may be configured to emit light having a third wavelength selected within a range of about 400 nm to about 490 nm. The light of the third wavelength may be blue light. Herein, the wavelength range of blue light may refer to a wavelength range of about 400 nm or more and less than about 490 nm, and there may be at least one peak of an emission spectrum in the wavelength range of blue light.

The first conductivity-type base layer 102, the first conductivity-type semiconductor layer 112, the active layer 114, and the second conductivity-type semiconductor layer 116 may each include an epitaxial nitride semiconductor layer. The first conductivity-type base layer 102 and the first conductivity-type semiconductor layer 112 may include nitride semiconductor layers doped with a dopant of the same conductivity type (e.g., an n-type dopant), and an average doping concentration of the first conductivity-type base layer 102 may be greater than an average doping concentration of the first conductivity-type semiconductor layer 112. The first conductivity-type semiconductor layer 112 and the second conductivity-type semiconductor layer 116 may each include a single layer or a multilayer including multiple layers having different dopant doping concentrations and different compositions of constituents.

In the light emitting structure 110, the first conductivity-type semiconductor layer 112 may be integrally connected to the first conductivity-type base layer 102 through the main surface 102M. For example, it is noted that a dashed line is shown at the main surface 102M. However, this dashed line is only for convenience of explanation and, in the case that the first conductivity-type semiconductor layer 112 is integrally connected to the first conductivity-type base layer 102, the line would not be actually present/visible. A width of the first conductivity-type base layer 102 in the horizontal direction may be greater than the width of the light emitting structure 110 in the horizontal direction.

In the light emitting device 10, an upper surface of the first conductivity-type base layer 102 is an uneven surface or structure 102P, and a portion of the uneven surface 102P may include a recess 102R having a depth and a flat bottom surface. The depth may be predefined. The uneven surface 102P of the first conductivity-type base layer 102 may be a result of texturing treatment to increase light emitting efficiency, and the recess 102R of the first conductivity-type base layer 102 may be a result of reducing resistance of a first contact electrode 192 described below. However, in some embodiments, the uneven surface 102P and/or recess 102R may be omitted on the upper surface of the first conductivity-type base layer 102.

In some embodiments, the first conductivity-type base layer 102 and the first conductivity-type semiconductor layer 112 may include the same material. For example, the first conductivity-type base layer 102 and the first conductivity-type semiconductor layer 112 may include n-type gallium nitride (n-GaN).

The first conductivity-type semiconductor layer 112 may include an n-type superlattice structure. For example, the first conductivity-type semiconductor layer 112 may include an InGaN/GaN superlattice structure. In this case, the first conductivity-type semiconductor layer 112 may have a superlattice structure in which InGaN films and GaN films are alternately stacked one by one. In the first conductivity-type semiconductor layer 112, the superlattice structure may include a pair structure of an InGaN film and a GaN film with about 10 periods to about 50 periods.

In some embodiments, the first conductivity-type semiconductor layer 112 may include a nitride semiconductor having a composition of InₓAl_{y}Ga_{1-x-y}N(0≤x<1, 0≤y<1, 0≤x+y<1). In some embodiments, the first conductivity-type semiconductor layer 112 may include n-type gallium nitride (n-GaN) doped with silicon (Si), germanium (Ge), or carbon (C). In some embodiments, the first conductivity-type semiconductor layer 112 may include a semiconductor layer of aluminum indium gallium phosphide (AlInGaP) or aluminum indium gallium arsenide (AlInGaAs).

In the light emitting structure 110, the active layer 114 may be configured to emit light having certain energy by recombination of electrons and holes. The active layer 114 may have a single or multi-quantum well structure in which quantum barrier layers and quantum well layers are alternately arranged. In some embodiments, the active layer 114 may have a single or multi-quantum well structure, including one to fifteen periods of one pair structure including one quantum barrier layer and one quantum well layer.

In some embodiments, the active layer 114 may include a quantum well layer and a quantum barrier layer including a compound semiconductor. For example, the active layer 114 may include any one pair structure selected from InGaN/GaN, InGaN/InGaN, InGaN/AlGaN, and InGaN/InAlGaN.

In some embodiments, the quantum well layer and the quantum barrier layer may include InₓAl_{y}Ga_{1-x-y}N(0≤x≤1, 0≤y≤1, 0≤x+y≤1) layers having different compositions. For example, the quantum well layer may include an undoped InₓGa₁₋ₓN(0<x<1) layer, and the quantum barrier layer may include an undoped GaN layer or a GaN layer doped with silicon (Si).

In some embodiments, when the quantum well layer included in the active layer 114 is an InₓGa₁₋ₓN(0<x<1) layer, band gap energy in the active layer 114 may be controlled according to the content ratio of indium (In) in the quantum well layer, thereby adjusting an emission wavelength band.

In the light emitting structure 110, the second conductivity-type semiconductor layer 116 may include a nitride semiconductor doped with a dopant (e.g., a p-type dopant) opposite to the dopant doped in the first conductivity-type semiconductor layer 112. In some embodiments, the second conductivity-type semiconductor layer 116 may include a nitride semiconductor having a composition of InₓAl_{y}Ga_{1-x-y}N(0≤x<1, 0≤y<1, 0≤x+y<1). For example, the second conductivity-type semiconductor layer 116 may include p-type gallium nitride (p-GaN) doped with magnesium (Mg) or zinc (Zn). In some embodiments, the second conductivity-type semiconductor layer 116 may include a semiconductor layer of aluminum indium gallium phosphide (AlInGaP) or aluminum indium gallium arsenide (AlInGaAs).

A transparent electrode layer 130 may cover the second conductivity-type semiconductor layer 116 from below the second conductivity-type semiconductor layer 116. The transparent electrode layer 130 may be in contact with the second conductivity-type semiconductor layer 116 and may be spaced apart from the active layer 114 in the vertical direction with the second conductivity-type semiconductor layer 116 therebetween. The second conductivity-type semiconductor layer 116 may overlay the transparent electrode layer 130.

The transparent electrode layer 130 may have a width that is the same as or similar to a width of the light emitting structure 110 in the horizontal direction. The transparent electrode layer 130 may include a transparent conductive material. In some embodiments, the transparent electrode layer 130 may include indium tin oxide (ITO), zinc-doped indium tin oxide (ZITO), zinc indium oxide (ZIO), gallium indium oxide (GIO), zinc tin oxide (ZTO), fluorine-doped tin oxide (FTO), aluminum-doped zinc oxide (AZO), gallium-doped zinc oxide (GZO), zinc magnesium oxide (ZnMgO), or combinations thereof.

A side wall of each of the first conductivity-type semiconductor layer 112, the active layer 114, and the second conductivity-type semiconductor layer 116 included in the light emitting structure 110 and a side wall of the transparent electrode layer 130 may be covered with a reflective structure 150. The reflective structure 150 may include a distributed Bragg reflector. The reflective structure 150 may have a structure in which a plurality of insulating layers are stacked in sequence.

The reflective structure 150 may play a role in controlling a light distribution by reflecting light traveling from the inside of the light emitting structure 110 to the side wall. Because the reflective structure 150 includes a distributed Bragg reflection layer, the reflective structure 150 may act as a band pass filter that suppresses the transmission of light having a certain wavelength, and because a difference in transmittance occurs depending on the angle of incidence, the light distribution may be effectively controlled. The reflective structure 150 may increase the intensity of light emitted from a certain region by utilizing the difference in transmittance according to the angle of incidence of light emitted from the light emitting structure 110.

A reflective electrode layer 170 may penetrate the reflective structure 150 in the vertical direction and contact the transparent electrode layer 130 and may be spaced apart from the second conductivity-type semiconductor layer 116 in the vertical direction with the transparent electrode layer 130 therebetween.

The reflective electrode layer 170 may include, but is not limited to, silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), titanium (Ti), titanium nitride (TiN), tantalum (Ta), tantalum nitride (TaN), tungsten (W), or combinations thereof, having the characteristics of reflecting light.

A lower insulating layer 160 may cover the reflective structure 150 and the reflective electrode layer 170 from below and may be in a lower portion (e.g., the lowermost position) of the light emitting device 10 in the vertical direction. The lower insulating layer 160 may include a first lower insulating layer 162, a second lower insulating layer 164, and a third lower insulating layer 166, depending on the position at which the lower insulating layer 160 is formed.

In some embodiments, the lower insulating layer 160 may include silicon oxide, silicon nitride, or combinations thereof. In some embodiments, the lower insulating layer 160 may include tetraethyl ortho silicate (TEOS), undoped silicate glass (USG), phosphosilicate glass (PSG), borosilicate glass (BSG), borophosphosilicate glass (BPSG), fluoride silicate glass (FSG), spin on glass (SOG), polysilazane, or combinations thereof.

The reflective electrode layer 170 may include a portion that contacts the lower insulating layer 160 and a portion that contacts the reflective structure 150. The number of reflective electrode layers 170 may be the same as the number of the light emitting structures 110.

An upper insulating layer 180 may cover the reflective structure 150 and the reflective electrode layer 170 from above in the vertical direction and surround a side surface of the first conductivity-type base layer 102. The upper insulating layer 180 may include a through-hole 180H that penetrates the upper insulating layer 180 and exposes the upper surface of the reflective electrode layer 170.

In some embodiments, the upper insulating layer 180 may include a material that is the same as or similar to the material that constitutes the lower insulating layer 160 described above.

The first contact electrode 192 may cover a portion of the upper surface of the first conductivity-type base layer 102 and a portion of the upper surface of the upper insulating layer 180 (best seen, for example, in FIG. 3). That is, the first contact electrode 192 may be conformally formed along the uneven surface 102P and recess 102R formed on the upper surface of the first conductivity-type base layer 102. Accordingly, the first contact electrode 192 may be electrically connected to the first conductivity-type semiconductor layer 112 through the first conductivity-type base layer 102.

A second contact electrode 194 may cover a portion of the upper surface of the upper insulating layer 180 and an inner wall of the through-hole 180H. That is, the second contact electrode 194 may contact the upper surface of the reflective electrode layer 170 through the through-hole 180H. Accordingly, the second contact electrode 194 may be electrically connected to the second conductivity-type semiconductor layer 116 through the reflective electrode layer 170 and the transparent electrode layer 130.

In some embodiments, the first contact electrode 192 and the second contact electrode 194 may include the same material. For example, each of the first contact electrode 192 and the second contact electrode 194 may include a transparent electrode material.

In some embodiments, the first contact electrode 192 and the second contact electrode 194 may include different materials. For example, the first contact electrode 192 may include a transparent electrode material, and the second contact electrode 194 may include a reflective electrode material.

In some embodiments, a plurality of the second contact electrodes 194 may be provided to correspond to the first to third light emitting structures 110R, 110G, and 110B. In some embodiments, the first contact electrode 192 may be a common electrode corresponding to all of the first to third light emitting structures 110R, 110G, and 110B.

In the light emitting device 10, when viewed in a plan view (e.g., FIG. 1), the first contact electrode 192 may cover all of the first to third light emitting structures 110R, 110G, and 110B, and a plurality of the second contact electrodes 194R, 194G, and 194B may be spaced apart from each other and arranged to face at least one side surface of the corresponding first to third light emitting structures 110R, 110G, and 110B. Each of the plurality of second contact electrodes 194R, 194G, and 194B may have a surface which faces a corresponding side surface of one of the plurality of light emitting structures (e.g., first to third light emitting structures 110R, 110G, and 110B) in a horizontal direction. For example, in some embodiments, the plurality of second contact electrodes 194R, 194G, and 194B may be respectively arranged at the corners of the first conductivity-type base layer 102, as illustrated in the example of FIG. 1.

In the light emitting device 10, when viewed in a cross-sectional view (e.g., FIG. 2), a vertical level of the uppermost surface of the second contact electrode 194 in the vertical direction may be higher than a vertical level of the uppermost surface of the first conductivity-type base layer 102 in the vertical direction, and a vertical level of the lowermost surface of the second contact electrode 194 in the vertical direction may be lower than a vertical level of the lowermost surface of the first conductivity-type base layer 102 in the vertical direction. In other words, the second contact electrode 194 may be arranged alongside of the first conductivity-type base layer 102 in the horizontal direction, but a length of the second contact electrode 194 in the vertical direction may be greater than a length of the first conductivity-type base layer 102 in the vertical direction.

In the light emitting device 10, when viewed in a cross-sectional view (e.g., FIG. 3), a direction in which the uppermost surface of each of the first contact electrode 192 and the second contact electrode 194 is positioned is the same as a direction of a light emitting surface in the vertical direction. In other words, the vertical levels of the uppermost surfaces of each of the first contact electrode 192 and the second contact electrode 194 are the same and the vertical levels of each of the first contact electrode 192 and the second contact electrode 194 are higher than the vertical level of the uppermost surface of the first conductivity-type base layer 102. These features may be features of the various embodiments that result from the manufacturing method of the light emitting device 10 described below. The light emitting surface may be the uppermost surface of the first conductivity-type base layer.

In the light emitting device 10, the first contact electrode 192 connected to the first conductivity-type semiconductor layer 112 and the second contact electrode 194 connected to the second conductivity-type semiconductor layer 116 may be formed in the same manufacturing process. Both the first contact electrode 192 and the second contact electrode 194 may be formed in the same direction (direction of the light emitting surface). The light emitting device 10 may have improved light extraction efficiency. The light emitting device 10 may have improved light extraction efficiency in an ultra-small light emitting device (i.e., micro-LED).

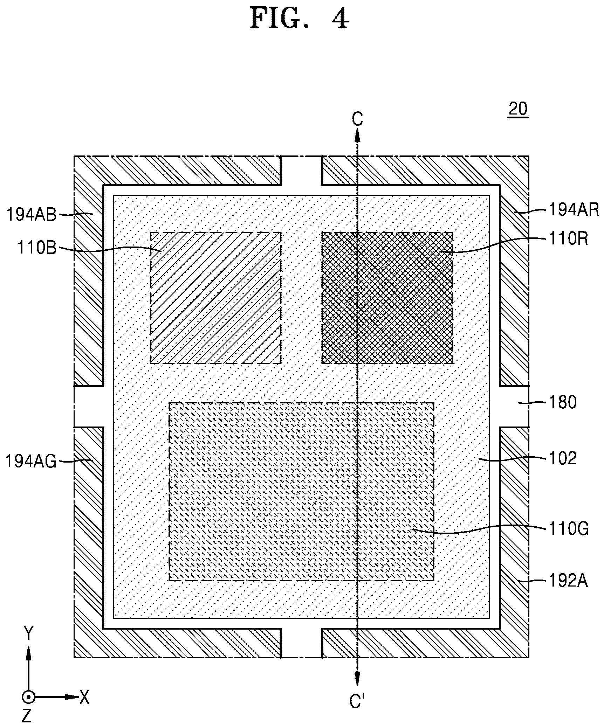

FIGS. 4 to 9 are diagrams illustrating light emitting devices according to some embodiments.

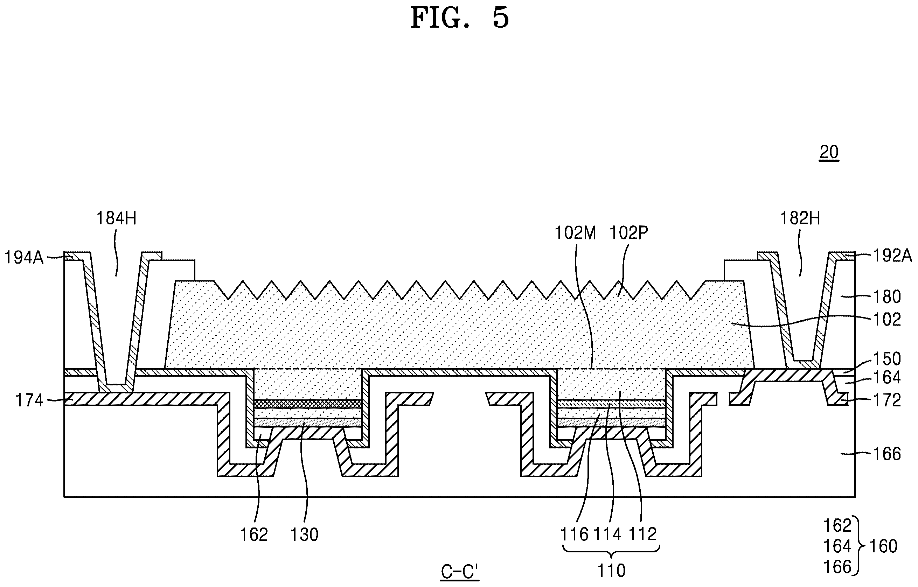

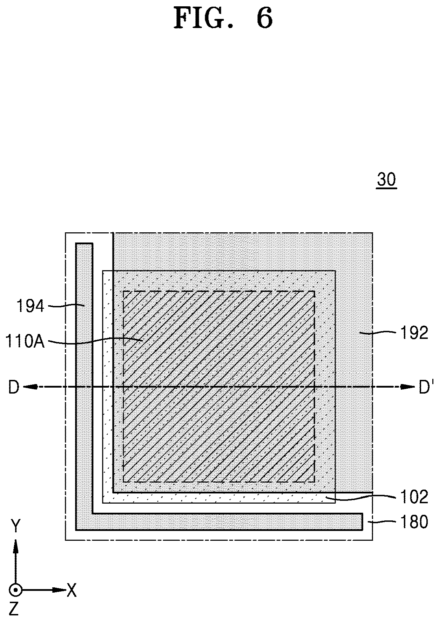

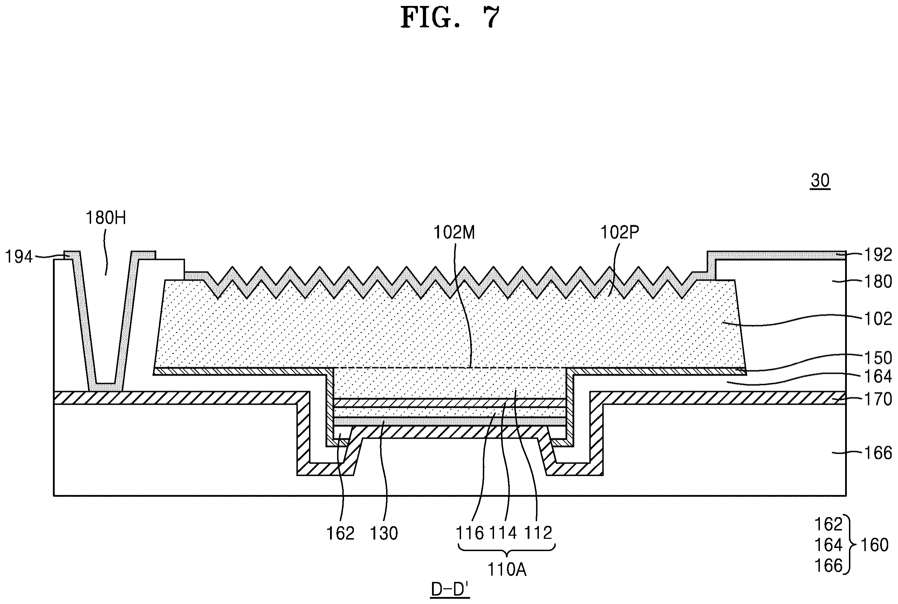

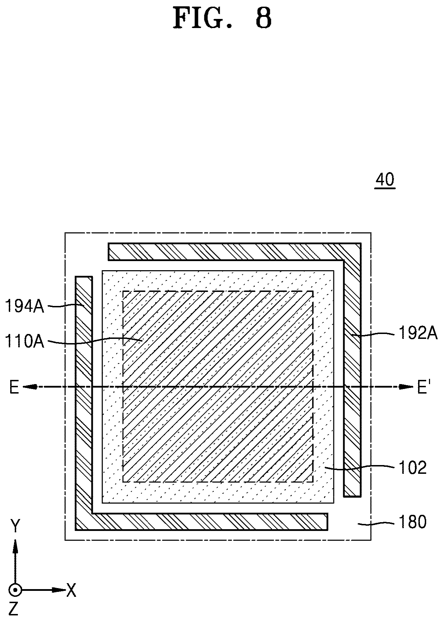

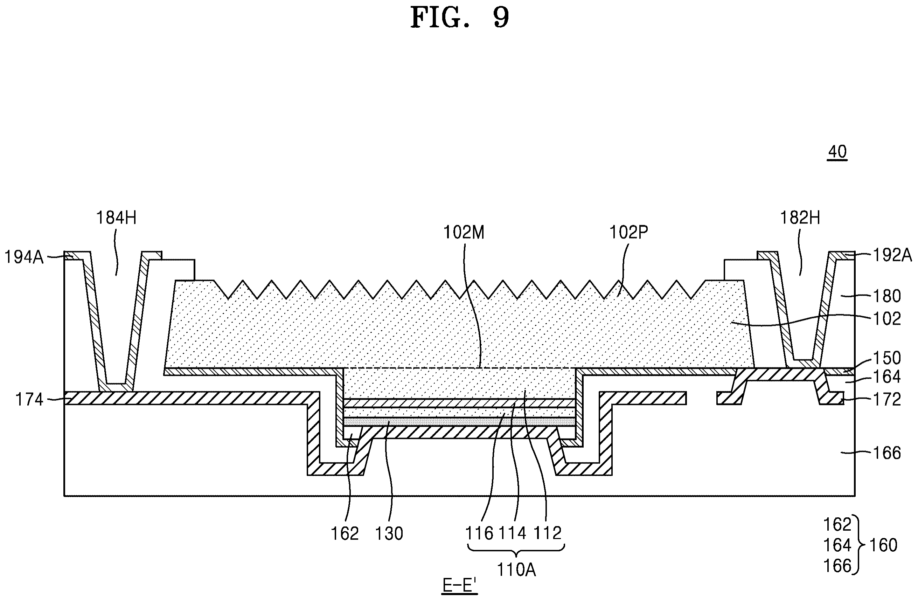

In detail, FIG. 4 is a plan view of a light emitting device 20, according to an embodiment, and FIG. 5 is a cross-sectional view taken along line C-C' of FIG. 4. FIG. 6 is a plan view of a light emitting device 30, according to an embodiment, and FIG. 7 is a cross-sectional view taken along line D-D' of FIG. 6. FIG. 8 is a plan view of a light emitting device 40, according to an embodiment, and FIG. 9 is a cross-sectional view taken along line E-E' of FIG. 8.

Most of the components included in the light emitting devices 20, 30, and 40 described below and the materials forming the components are substantially the same as or similar to those described above with reference to FIGS. 1 to 3. In FIGS. 4-8, same components are labeled with same reference designators as used in FIGS. 1 to 3 and repeated description thereof is omitted for conciseness. Therefore, for convenience of description, the differences from the light emitting device 10 described above are mainly described.

Referring to FIGS. 4 and 5 together, the light emitting device 20 may include the first conductivity-type base layer 102 and the plurality of light emitting structures 110 arranged below the main surface 102M of the first conductivity-type base layer 102.

The light emitting device 20 may include a first reflective electrode layer 172 that penetrates the reflective structure 150 in the vertical direction and contacts the first conductivity-type base layer 102, e.g., the main surface 102M of the first conductivity-type base layer 102, and a second reflective electrode layer 174 that penetrates the reflective structure 150 in the vertical direction and contacts the transparent electrode layer 130.

The light emitting device 20 may include an upper insulating layer 180 that covers the reflective structure 150, the first reflective electrode layer 172, and the second reflective electrode layer 174 from above and surrounds the side surface of the first conductivity-type base layer 102. The upper insulating layer 180 may include a first through-hole 182H that penetrates the upper insulating layer 180 and exposes an upper surface of the first reflective electrode layer 172 and a second through-hole 184H that penetrates the upper insulating layer 180 and exposes an upper surface of the second reflective electrode layer 174.

A first contact electrode 192A may cover a portion of the upper surface of the upper insulating layer 180 and an inner wall of the first through-hole 182H. That is, the first contact electrode 192A may contact the upper surface of the first reflective electrode layer 172 through the first through-hole 182H. Accordingly, the first contact electrode 192A may be electrically connected to the first conductivity-type semiconductor layer 112 through the first reflective electrode layer 172 and the first conductivity-type base layer 102.

A second contact electrode 194A may cover a portion of the upper surface of the upper insulating layer 180 and an inner wall of the second through-hole 184H. That is, the second contact electrode 194A may contact the upper surface of the second reflective electrode layer 174 through the second through-hole 184H. Accordingly, the second contact electrode 194A may be electrically connected to the second conductivity-type semiconductor layer 116 through the second reflective electrode layer 174 and the transparent electrode layer 130.

In some embodiments, the first contact electrode 192A and the second contact electrode 194A may include the same material. That is, each of the first contact electrode 192A and the second contact electrode 194A may include a reflective electrode material.

In the light emitting device 20, when viewed in a plan view (e.g., FIG. 4), the first contact electrode 192A and the plurality of second contact electrodes 194AR, 194AG, and 194AB may be respectively positioned at corners of the first conductivity-type base layer 102.

In the light emitting device 20, when viewed in a cross-sectional view (e.g., FIG. 5), a vertical level of the uppermost surface of each of the first contact electrode 192A and the second contact electrode 194A in the vertical direction may be higher than a vertical level of the uppermost surface of the first conductivity-type base layer 102 in the vertical direction, and a vertical level of the lowermost surface of each of the first contact electrode 192A and the second contact electrode 194A in the vertical direction may be equal to or lower than a vertical level of the lowermost surface of the first conductivity-type base layer 102 in the vertical direction. In other words, each of the first contact electrode 192A and the second contact electrode 194A is arranged alongside of the first conductivity-type base layer 102, but a length of each of the first contact electrode 192A and the second contact electrode 194A in the vertical direction may be greater than a length of the first conductivity-type base layer 102 in the vertical direction.

In the light emitting device 20, the first contact electrode 192A connected to the first conductivity-type semiconductor layer 112 and the second contact electrode 194A connected to the second conductivity-type semiconductor layer 116 may be formed during the same manufacturing process. Both the first contact electrode 192A and the second contact electrode 194A may be formed in the same direction (in the direction of the light emitting surface). Both the first contact electrode 192A and the second contact electrode 194A may include a reflective electrode material. The light emitting device 20 may have improved light extraction efficiency. The light emitting device 20 may have improved light extraction efficiency in an ultra-small light emitting device (i.e., a micro-LED).

Referring to FIGS. 6 and 7 together, a light emitting device 30 may include the first conductivity-type base layer 102 and one light emitting structure 110A located below the main surface 102M of the first conductivity-type base layer 102.

In the light emitting device 30, the light emitting structure 110A may include the first conductivity-type semiconductor layer 112, the active layer 114, and the second conductivity-type semiconductor layer 116 sequentially stacked in the vertical direction perpendicular to the main surface 102M of the first conductivity-type base layer 102.

The light emitting device 30 may include a single light emitting structure 110A that emits light having one wavelength. The light emitting structure 110A may be configured to emit light having a wavelength λ within the range of about 400 nm to about 700 nm.

In some embodiments, the light emitting structure 110A may be configured to emit red light having a wavelength within the range of about 580 nm to about 700 nm. In some embodiments, the light emitting structure 110A may be configured to emit green light having a wavelength within the range of about 490 nm to about 580 nm. In some embodiments, the light emitting structure 110A may be configured to emit blue light having a wavelength within the range of about 400 nm to about 490 nm.

In some embodiments, the first contact electrode 192 and the second contact electrode 194 may include the same material. That is, each of the first contact electrode 192 and the second contact electrode 194 may include a transparent electrode material.

In the light emitting device 30, the first contact electrode 192 connected to the first conductivity-type semiconductor layer 112 and the second contact electrode 194 connected to the second conductivity-type semiconductor layer 116 may be formed during the same manufacturing process. Both the first contact electrode 192 and the second contact electrode 194 may be formed in the same direction (direction of the light emitting surface). The light emitting device 30 may have improved light extraction efficiency. The light emitting device 30 may have improved light extraction efficiency in an ultra-small light emitting device (i.e., micro-LED) that emits one of red, green, and blue colors. In a plan view, e.g., Figure 6, the first contact electrode 192 may cover (e.g., overlay) all of the single light emitting structure 110A in the vertical direction. The second electrode 194 may be spaced apart from the single light emitting structure 110, e.g., in a horizontal direction. A side surface of the second electrode 194 may face at least one side surface of the single light emitting structure 110A.

Referring to FIGS. 8 and 9 together, a light emitting device 40 may include the first conductivity-type base layer 102 and one light emitting structure 110A located below the main surface 102M of the first conductivity-type base layer 102.

In the light emitting device 40, the light emitting structure 110A may include the first conductivity-type semiconductor layer 112, the active layer 114, and the second conductivity-type semiconductor layer 116 sequentially stacked in the vertical direction perpendicular to the main surface 102M of the first conductivity-type base layer 102.

The light emitting device 40 may include a single light emitting structure 110A that emits light having one wavelength. The light emitting structure 110A may be configured to emit light having a wavelength λ within the range of about 400 nm to about 700 nm.

In some embodiments, the light emitting structure 110A may be configured to emit red light having a wavelength within the range of about 580 nm to about 700 nm. In some embodiments, the light emitting structure 110A may be configured to emit green light having a wavelength within the range of about 490 nm to about 580 nm. In some embodiments, the light emitting structure 110A may be configured to emit blue light having a wavelength within the range of about 400 nm to about 490 nm.

The light emitting device 40 may include the first reflective electrode layer 172 that penetrates the reflective structure 150 in the vertical direction and contacts the main surface 102M of the first conductivity-type base layer 102, and the second reflective electrode layer 174 that penetrates the reflective structure 150 in the vertical direction and contacts the transparent electrode layer 130.

The light emitting device 40 may include the upper insulating layer 180 that covers the reflective structure 150, the first reflective electrode layer 172, and the second reflective electrode layer 174 from above and surrounds the side surface of the first conductivity-type base layer 102. The upper insulating layer 180 may include the first through-hole 182H that penetrates the upper insulating layer 180 and exposes an upper surface of the first reflective electrode layer 172 and the second through-hole 184H that penetrates the upper insulating layer 180 and exposes an upper surface of the second reflective electrode layer 174.

The first contact electrode 192A may be located to cover a portion of the upper surface of the upper insulating layer 180 and an inner wall of the first through-hole 182H. That is, the first contact electrode 192A may contact the upper surface of the first reflective electrode layer 172 through the first through-hole 182H. Accordingly, the first contact electrode 192A may be electrically connected to the first conductivity-type semiconductor layer 112 through the first reflective electrode layer 172 and the first conductivity-type base layer 102.

The second contact electrode 194A may be positioned to cover a portion of the upper surface of the upper insulating layer 180 and the inner wall of the second through-hole 184H. That is, the second contact electrode 194A may contact the upper surface of the second reflective electrode layer 174 through the second through-hole 184H. Accordingly, the second contact electrode 194A may be electrically connected to the second conductivity-type semiconductor layer 116 through the second reflective electrode layer 174 and the transparent electrode layer 130.

In some embodiments, the first contact electrode 192A and the second contact electrode 194A may include the same material. That is, each of the first contact electrode 192A and the second contact electrode 194A may include a reflective electrode material.

In the light emitting device 40, the first contact electrode 192A connected to the first conductivity-type semiconductor layer 112 and the second contact electrode 194A connected to the second conductivity-type semiconductor layer 116 may be formed during the same manufacturing process. Both the first contact electrode 192A and the second contact electrode 194A may be formed in the same direction (in the direction of the light emitting surface). Both the first contact electrode 192A and the second contact electrode 194A may include a reflective electrode material. The light extraction device 40 may have improved light extraction efficiency. The light extraction device 40 may have improved light extraction efficiency in an ultra-small light emitting device (i.e., a micro-LED) that emits one of red, green, and blue colors.

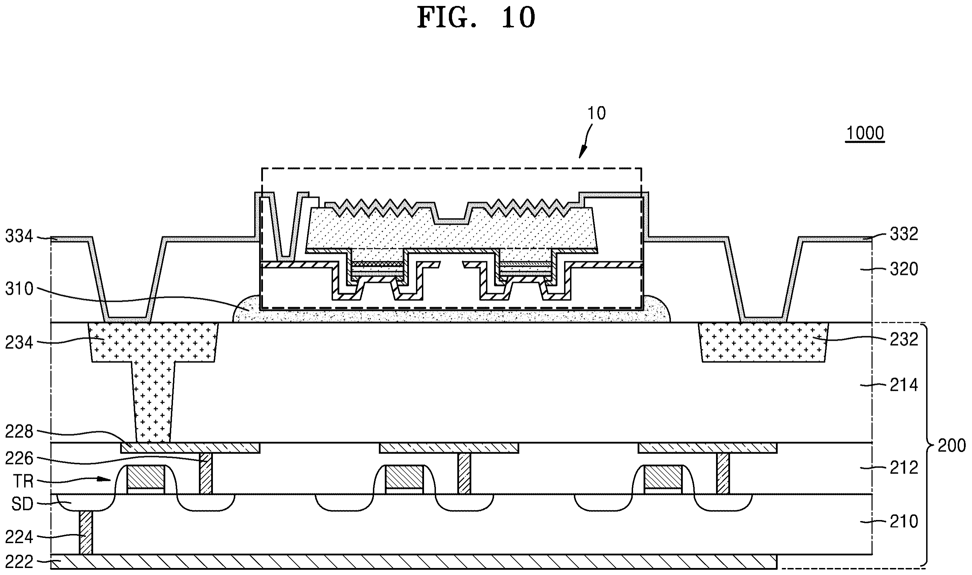

FIG. 10 is a cross-sectional view illustrating a display apparatus 1000 according to an embodiment.

Referring to FIG. 10, the display apparatus 1000 may include the light emitting device 10 and a circuit board 200 on which the light emitting device 10 is mounted.

The light emitting device 10 is substantially the same as or similar to that described above. In FIG. 10, same components are labeled with same reference designators as used in FIGS. 1 to 3 and repeated description thereof is omitted for conciseness. For convenience of description, the light emitting device 10 is illustrated, but in various embodiments, the display apparatus 1000 may include any one of the light emitting devices 20, 30, and 40 described above, instead of the light emitting device 10. The light emitting device 10 may be mounted on and bonded to the circuit board 200 using an adhesive material 310.

The circuit board 200 may be a driving circuit board including a transistor TR. In some embodiments, the circuit board 200 may include an application-specific integrated circuit (ASIC) having a driver circuit. In some embodiments, the circuit board 200 may include a flexible substrate. In this case, the display apparatus 1000 may be implemented as a rollable, stretchable, or curved display apparatus.

The circuit board 200 may include a semiconductor substrate 210, a driving circuit formed on the semiconductor substrate 210 and including a transistor TR, an interconnection portion 226 electrically connected to the transistor TR, and an interconnection line 228 connected to the interconnection portion 226.

The semiconductor substrate 210 may include an impurity region forming a source/drain region SD of the transistor TR. The semiconductor substrate 210 may include a through-electrode 224, such as a through-silicon via (TSV), connected to the transistor TR, and a substrate interconnection 222 connected to the through-electrode 224.

The circuit board 200 may include a first insulating layer 212 covering the transistor TR that constitutes the driving circuit, the interconnection portion 226, and the interconnection line 228.

The circuit board 200 may further include a second insulating layer 214 on the first insulating layer 212, a first conductive line 232 located within the second insulating layer 214, and a second conductive line 234 penetrating the second insulating layer 214 and connected to the interconnection line 228.

The display apparatus 1000 may include a peripheral insulating layer 320 surrounding the periphery of the light emitting device 10 and the adhesive material 310 on the second insulating layer 214, the first conductive line 232, and the second conductive line 234 of the circuit board 200.

The display apparatus 1000 may include a first connection line 332 that extends through the peripheral insulating layer 320 in the horizontal direction and is connected to the first contact electrode 192 of the light emitting device 10 and the first conductive line 232.

The display apparatus 1000 may include a second connection line 334 that extends through the peripheral insulating layer 320 in the horizontal direction and is connected to the second contact electrode 194 of the light emitting device 10 and the second conductive line 234.

In the display apparatus 1000, each of the second contact electrodes 194R, 194G, and 194B of the light emitting device 10 may be connected to the corresponding transistor TR through the second connection line 334 and the second conductive line 234.

Because the display apparatus 1000 includes the first connection line 332 connected to the first contact electrode 192 and the second connection line 334 connected to the second contact electrode 194 in the same direction (the direction of the light emitting surface) of the light emitting device 10, a light extraction efficiency of an ultra-small light emitting device (i.e., micro-LED) included therein may be improved.

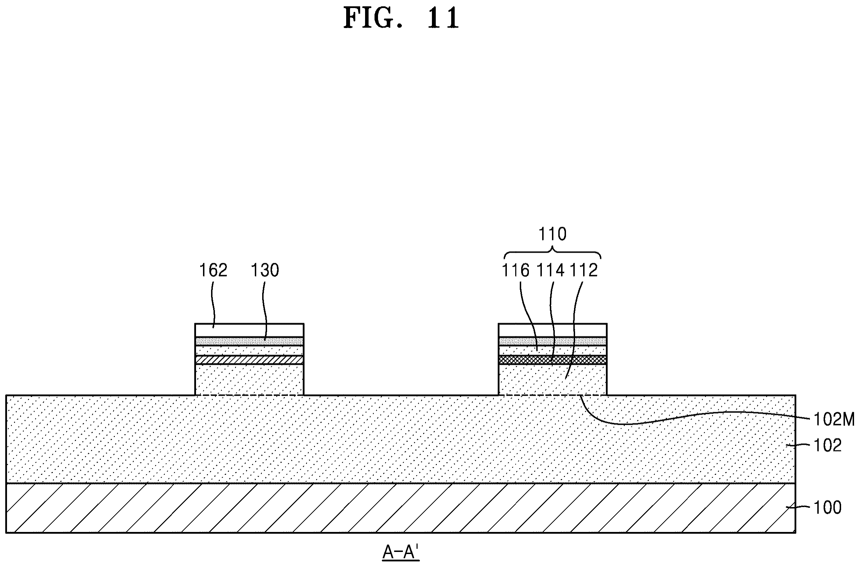

FIGS. 11 to 20 are cross-sectional views illustrating a sequential process of a method of manufacturing a light emitting device according to an embodiment.

In some embodiments, where the implementation is otherwise feasible, specific process sequences may be performed in a different order than described. For example, two processes described sequentially may be performed substantially simultaneously or may be performed in the reverse order from that described.

Referring to FIG. 11, the first conductivity-type base layer 102, the first conductivity-type semiconductor layer 112, the active layer 114, and the second conductivity-type semiconductor layer 116 may be sequentially formed on a growth substrate 100, and the transparent electrode layer 130 and the first lower insulating layer 162 may be formed on the second conductivity-type semiconductor layer 116.

Next, a portion of each of the first lower insulating layer 162, the transparent electrode layer 130, the second conductivity-type semiconductor layer 116, the active layer 114, and the first conductivity-type semiconductor layer 112 is etched by an etching process using a mask pattern as an etching mask, so that the plurality of light emitting structures 110 apart from each other on the first conductivity-type base layer 102, a plurality of transparent electrode layers 130 and a plurality of first lower insulating layers 162 covering the plurality of light emitting structures 110 may remain.

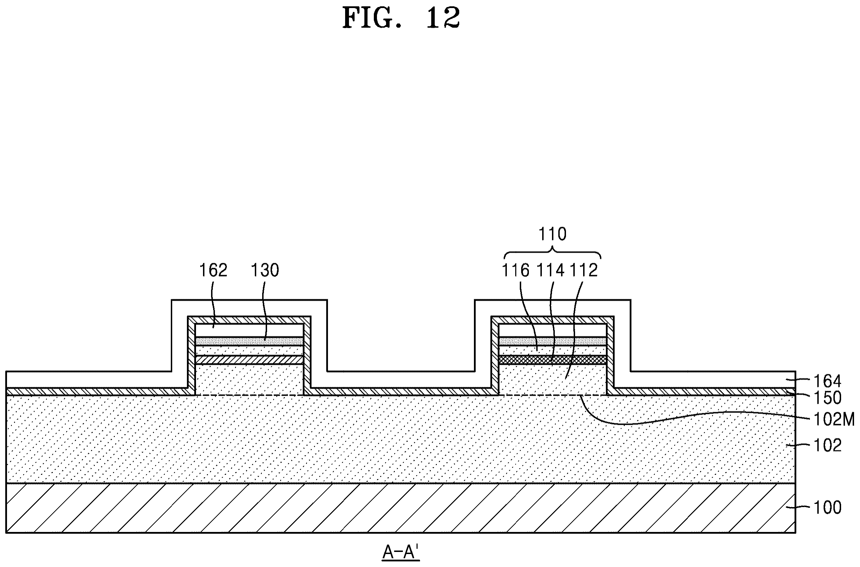

Referring to FIG. 12, the reflective structure 150 and the second lower insulating layer 164 may be formed to conformally cover the surface of each of the first conductivity-type base layer 102, the plurality of light emitting structures 110, the plurality of transparent electrode layers 130, and the plurality of first lower insulating layers 162 in a resultant structure of FIG. 11.

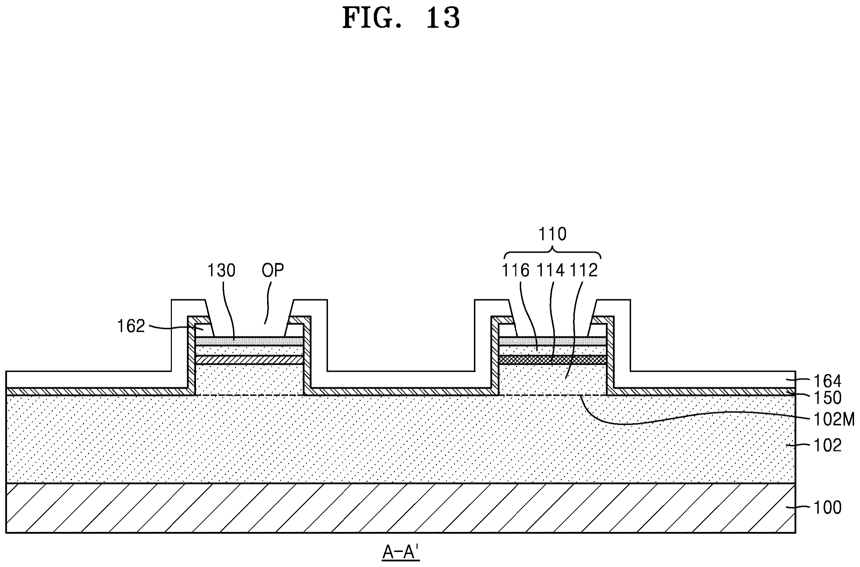

Referring to FIG. 13, a portion of each of the plurality of first lower insulating layers 162, the reflective structure 150, and the second lower insulating layer 164 may be etched so that the upper surfaces of the plurality of transparent electrode layers 130 are exposed in a resultant structure of FIG. 12 to form a plurality of openings OP.

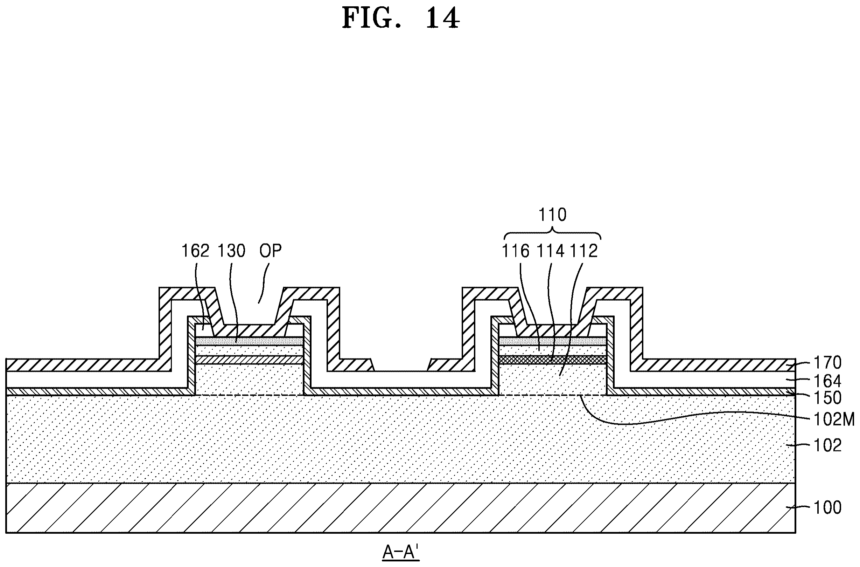

Referring to FIG. 14, a reflective electrode layer 170 may be formed to conformally cover the plurality of openings OP exposing the plurality of transparent electrode layers 130 and the reflective structure 150 and the second lower insulating layer 164 surrounding the openings in a resultant structure of FIG. 13.

The reflective electrode layer 170 may be formed in plurality to correspond to the plurality of light emitting structures 110. The plurality of reflective electrode layers 170 are formed to conformally cover the plurality of openings OP and the second lower insulating layer 164 so as to be electrically connected to the plurality of transparent electrode layers 130, but may be cut between the light emitting structures 110.

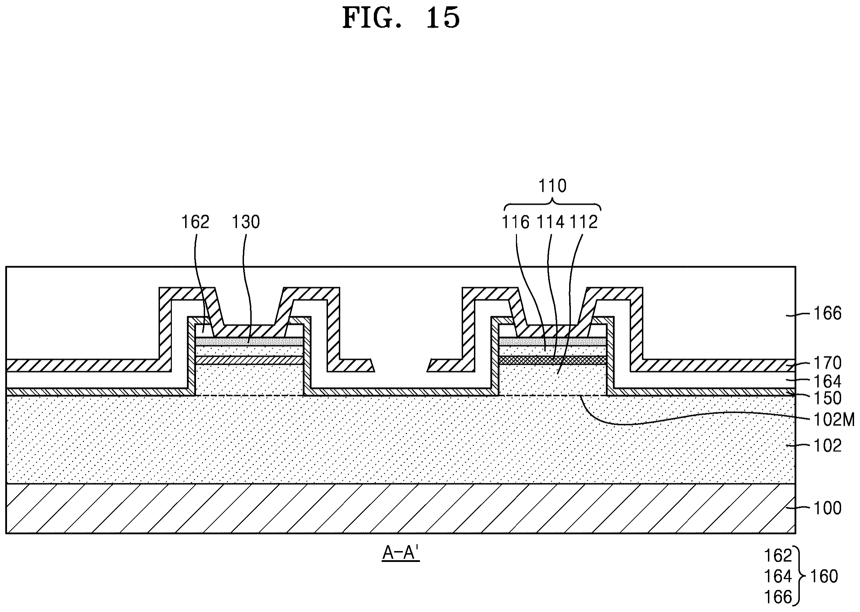

Referring to FIG. 15, the third lower insulating layer 166 may be formed to cover the reflective electrode layer 170 and the second lower insulating layer 164 in a resultant structure of FIG. 14. The third lower insulating layer 166 may be formed to have a flat upper surface.

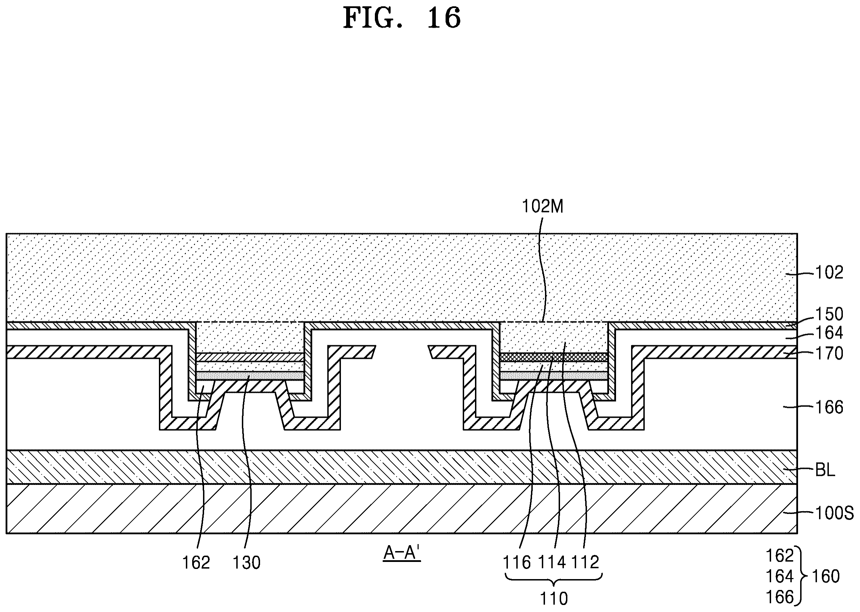

Referring to FIG. 16, an adhesive layer BL may be formed on the upper surface of the third lower insulating layer 166 in a resultant structure of FIG. 15, and a carrier substrate 100S may be attached on the adhesive layer BL.

Next, the carrier substrate 100S may be turned over to face downward in the vertical direction, so that the first conductivity-type base layer 102 may be placed to face upward.

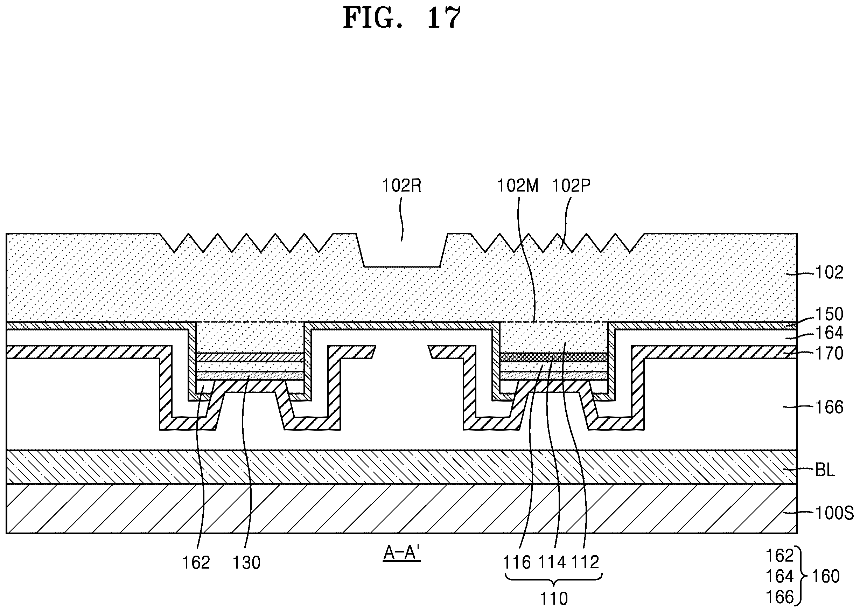

Referring to FIG. 17, a texturing process may be performed on the upper surface of the first conductivity-type base layer 102 of a resultant structure of FIG. 16 to form the uneven surface 102P.

Next, the recess 102R having a certain depth and a flat bottom surface may be formed in a portion of the uneven surface 102P of the first conductivity-type base layer 102. The certain depth of the recess 102R may be greater than a length from a peak to a valley of the uneven surface 102P in the vertical direction. The recess 102R may be formed by a dry etching process, and thus may have a tapered shape with a width that narrows downward.

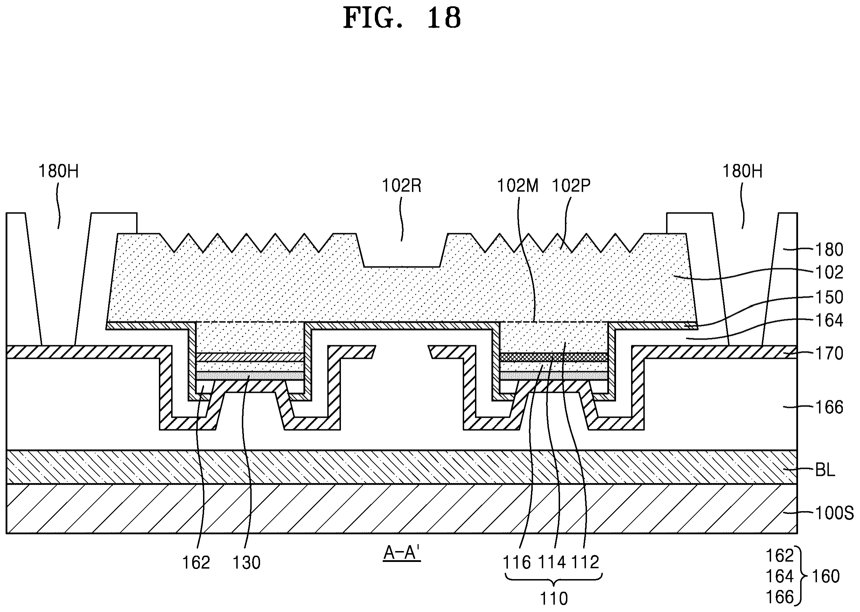

Referring to FIG. 18, an outer portion of the first conductivity-type base layer 102 in a resultant structure of FIG. 17 may be removed to expose the reflective electrode layer 170, and the upper insulating layer 180 may be formed to cover the exposed reflective electrode layer 170 and a portion of the first conductivity-type base layer 102.

Next, the through-hole 180H may be formed that penetrates the upper insulating layer 180 and exposes the upper surface of the reflective electrode layer 170. The through-hole 180H may be formed by a dry etching process, and thus may have a tapered shape with a width that narrows downward.

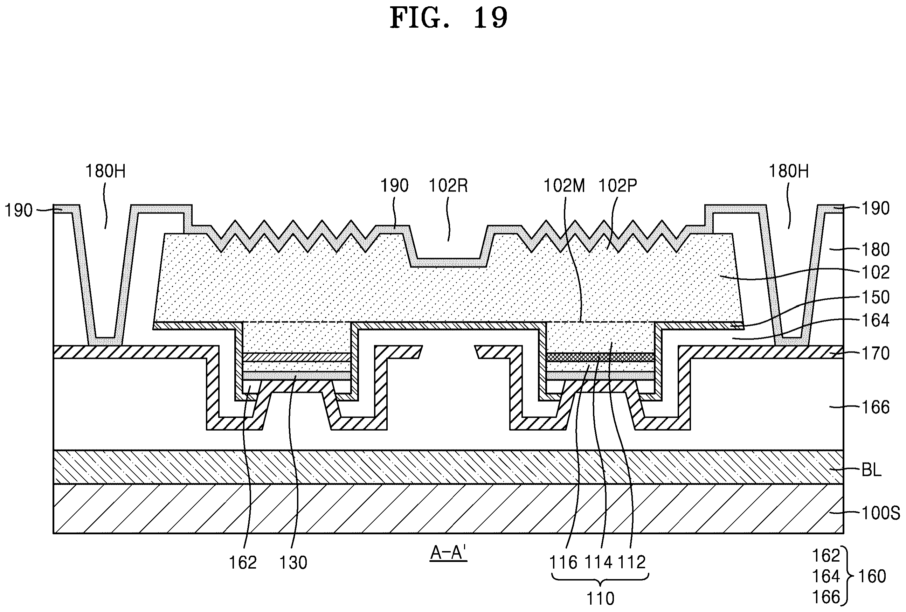

Referring to FIG. 19, a contact formation layer 190 may be conformally formed on the upper surface of the upper insulating layer 180, the inner wall of the through-hole 180H, the upper surface of the exposed reflective electrode layer 170, the upper surface of the first conductivity-type base layer 102 (the uneven surface 102P and the recess 102R) of a resultant structure of FIG. 18. That is, the contact formation layer 190 may be formed to cover all surfaces exposed upward.

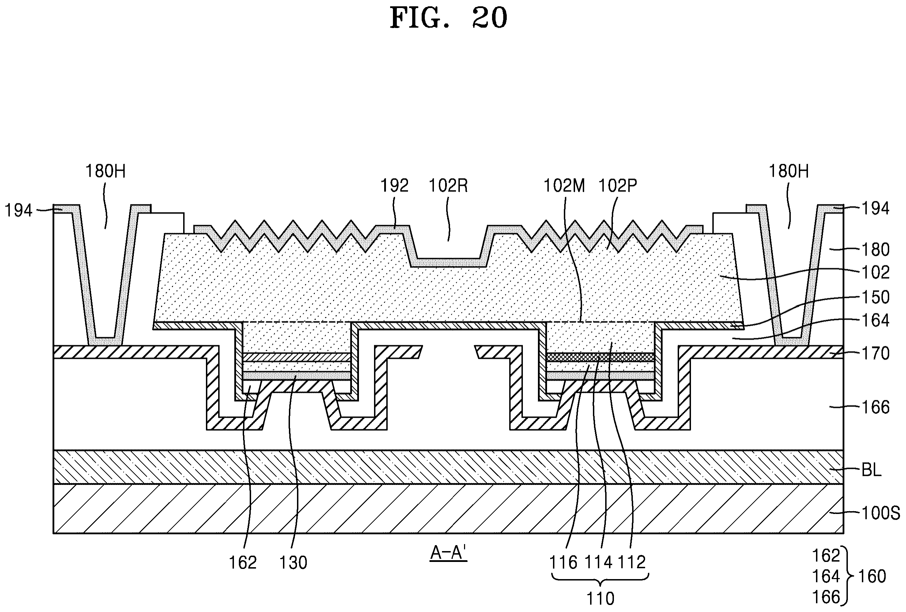

Referring to FIG. 20, a portion of the contact formation layer 190 may be etched by an etching process using a mask pattern as an etching mask in a resultant structure of FIG. 19 to separately form the first contact electrode 192 and the second contact electrode 194. Accordingly, the first contact electrode 192 and the second contact electrode 194 may include the same material.

However, in case that one of the first contact electrode 192 and the second contact electrode 194 is formed first and the other is formed later, the first contact electrode 192 and the second contact electrode 194 may include different materials.

The first contact electrode 192 may be formed to cover a portion of the upper surface of the first conductivity-type base layer 102 and a portion of the upper surface of the upper insulating layer 180. That is, the first contact electrode 192 may be conformally formed on the uneven surface 102P and recess 102R formed on the upper surface of the first conductivity-type base layer 102.

The second contact electrode 194 may be formed to cover a portion of the upper surface of the upper insulating layer 180 and the inner wall of the through-hole 180H. That is, the second contact electrode 194 may contact the upper surface of the reflective electrode layer 170 through the through-hole 180H.

Referring back to FIGS. 1 to 3, the adhesive layer BL and the carrier substrate 100S may be removed from a resultant structure of FIG. 20 to manufacture the light emitting device 10.

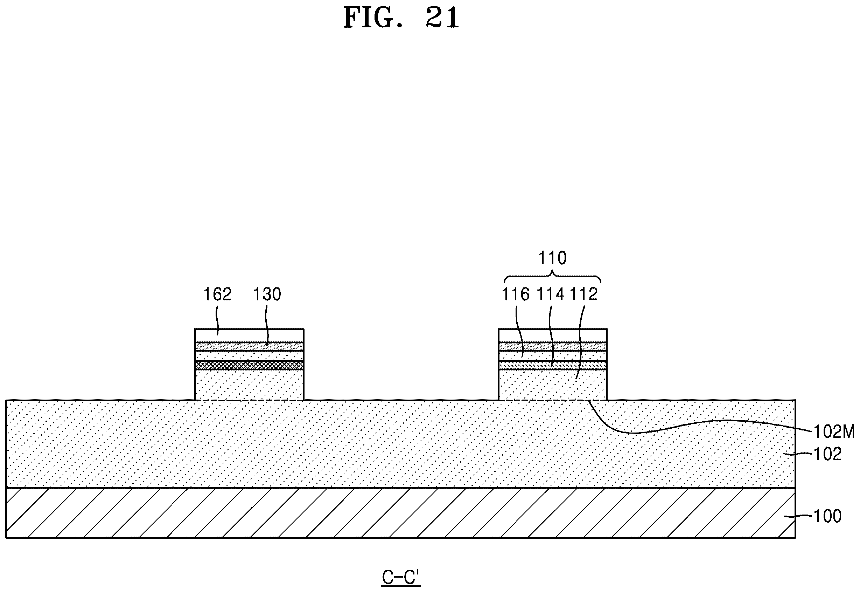

FIGS. 21 to 32 are cross-sectional views illustrating a sequential process of a method of manufacturing light emitting devices according to some embodiments.

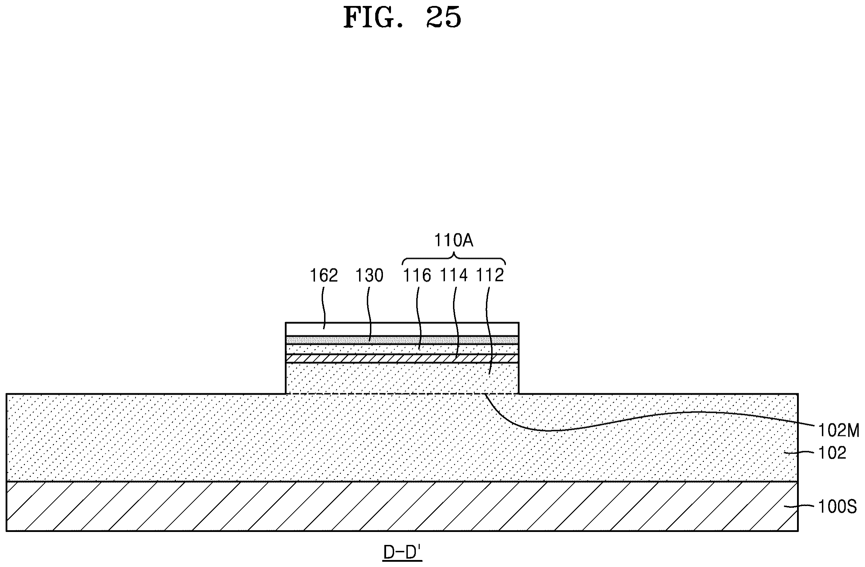

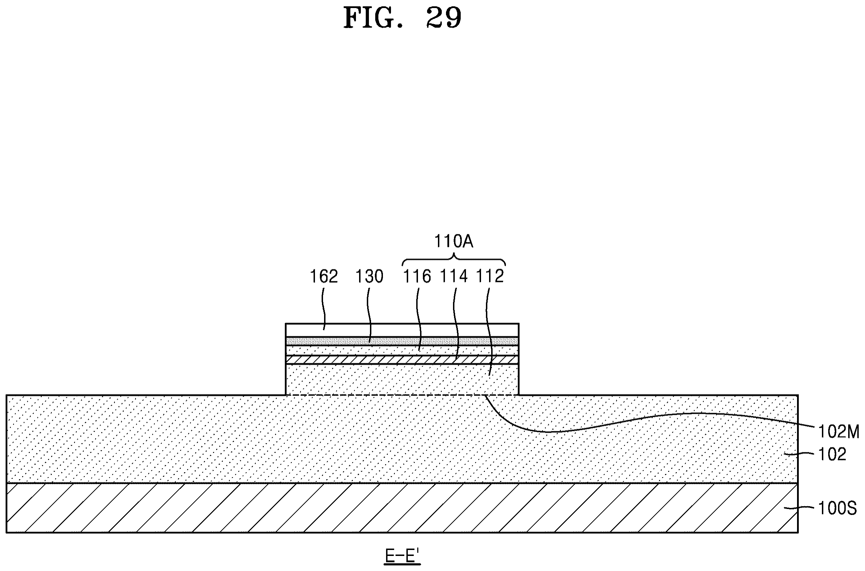

For example, FIGS. 21 to 24 illustrate a portion of the method of manufacturing the light emitting device 20, according to an embodiment. FIGS. 25 to 28 illustrate a portion of the method of manufacturing the light emitting device 30, according to an embodiment. FIGS. 29 to 32 illustrate a portion of the method of manufacturing the light emitting device 40, according to an embodiment.

Referring to FIG. 21, the first conductivity-type base layer 102, the first conductivity-type semiconductor layer 112, the active layer 114, and the second conductivity-type semiconductor layer 116 are sequentially formed on the growth substrate 100, and the transparent electrode layer 130 and the first lower insulating layer 162 are formed on the second conductivity-type semiconductor layer 116.

Next, a portion of each of the first lower insulating layer 162, the transparent electrode layer 130, the second conductivity-type semiconductor layer 116, the active layer 114, and the first conductivity-type semiconductor layer 112 is etched by an etching process using a mask pattern as an etching mask, so that the plurality of light emitting structures 110 apart from each other on the first conductivity-type base layer 102, the plurality of transparent electrode layers 130 and the plurality of first lower insulating layers 162 covering the light emitting structures 110 may remain.

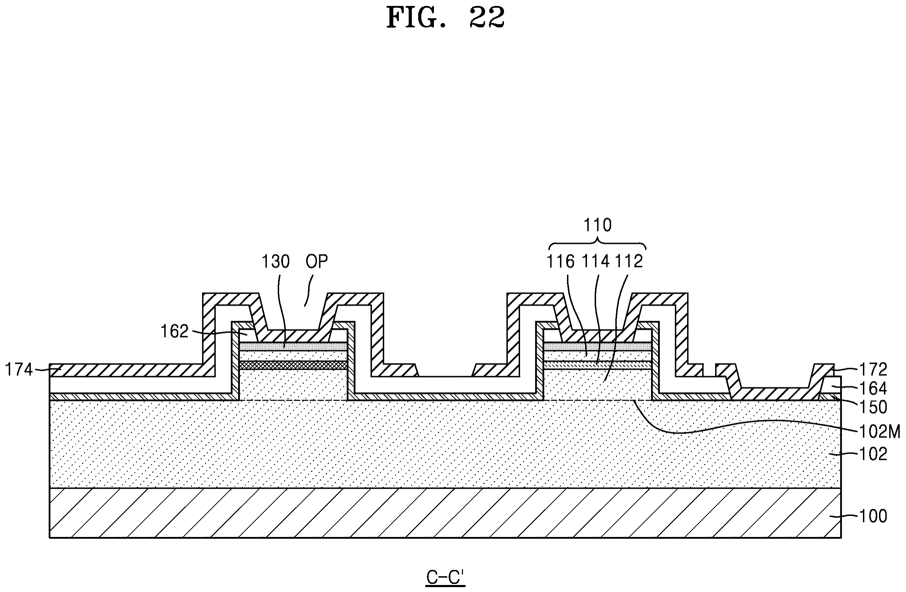

Referring to FIG. 22, after performing a process similar to the processes of FIGS. 12 and 13 on a resultant structure of FIG. 21, the first reflective electrode layer 172 in contact with a portion of the main surface 102M of the first conductivity-type base layer 102 and the second reflective electrode layer 174 covering the plurality of openings OP exposing the plurality of transparent electrode layers 130 and the reflective structure 150 and the second lower insulating layer 164 around the openings may be formed.

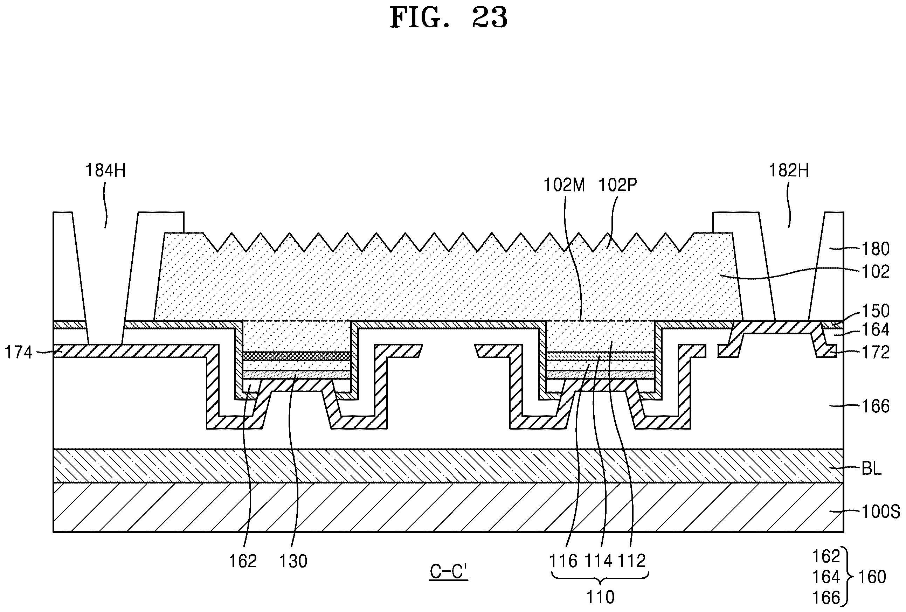

Referring to FIG. 23, after performing a process similar to the processes of FIGS. 15 to 17 on a resultant structure of FIG. 22, an outer portion of the first conductivity-type base layer 102 may be removed to expose the first reflective electrode layer 172 and the second reflective electrode layer 174, and the upper insulating layer 180 may be formed to cover the exposed first reflective electrode layer 172 and second reflective electrode layer 174.

Next, the first through-hole 182H that penetrates the upper insulating layer 180 and exposes the upper surface of the first reflective electrode layer 172 may be formed, and the second through-hole 184H that penetrates the upper insulating layer 180 and exposes the upper surface of the second reflective electrode layer 174 may be formed.

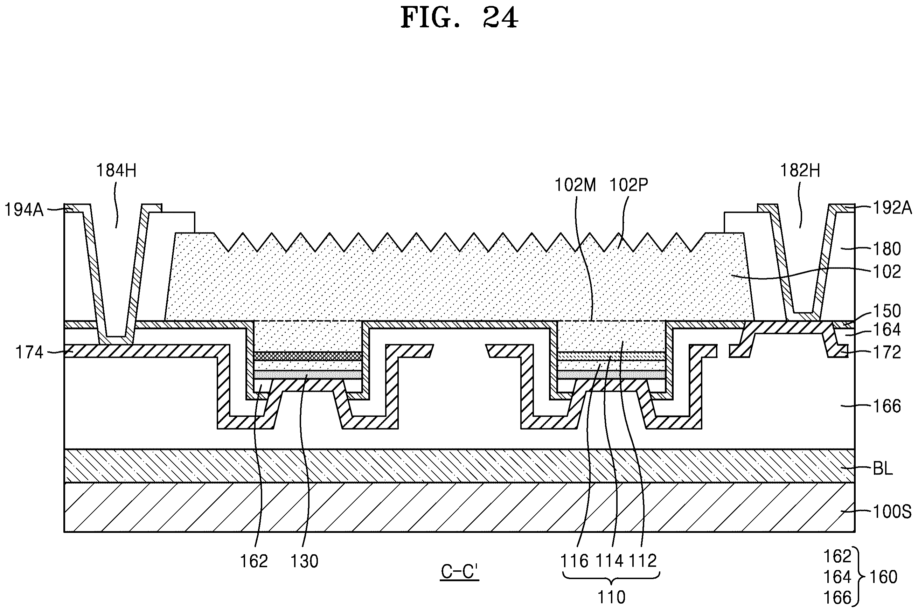

Referring to FIG. 24, a portion of the contact formation layer (not shown) may be etched by an etching process using a mask pattern as an etching mask in a resultant structure of FIG. 23 to form the first contact electrode 192A and the second contact electrode 194A separately. Accordingly, the first contact electrode 192A and the second contact electrode 194A may include the same material.

The first contact electrode 192A may be formed to cover the inner wall of the first through-hole 182H and the upper surface of the first reflective electrode layer 172. The second contact electrode 194A may be formed to cover the inner wall of the second through-hole 184H and the upper surface of the second reflective electrode layer 174.

Referring back to FIGS. 4 and 5, the adhesive layer BL and the carrier substrate 100S may be removed from a resultant structure of FIG. 24 to manufacture the light emitting device 20.

Referring to FIG. 25, the first conductivity-type base layer 102, the first conductivity-type semiconductor layer 112, the active layer 114, and the second conductivity-type semiconductor layer 116 are sequentially formed on the growth substrate 100, and the transparent electrode layer 130 and the first lower insulating layer 162 are formed on the second conductivity-type semiconductor layer 116.

Next, a portion of each of the first lower insulating layer 162, the transparent electrode layer 130, the second conductivity-type semiconductor layer 116, the active layer 114, and the first conductivity-type semiconductor layer 112 may be etched by an etching process using a mask pattern as an etching mask, so that one light emitting structure 110A, one transparent electrode layer 130 covering one light emitting structure 110A, and one first lower insulating layer 162 may remain on the first conductivity-type base layer 102.

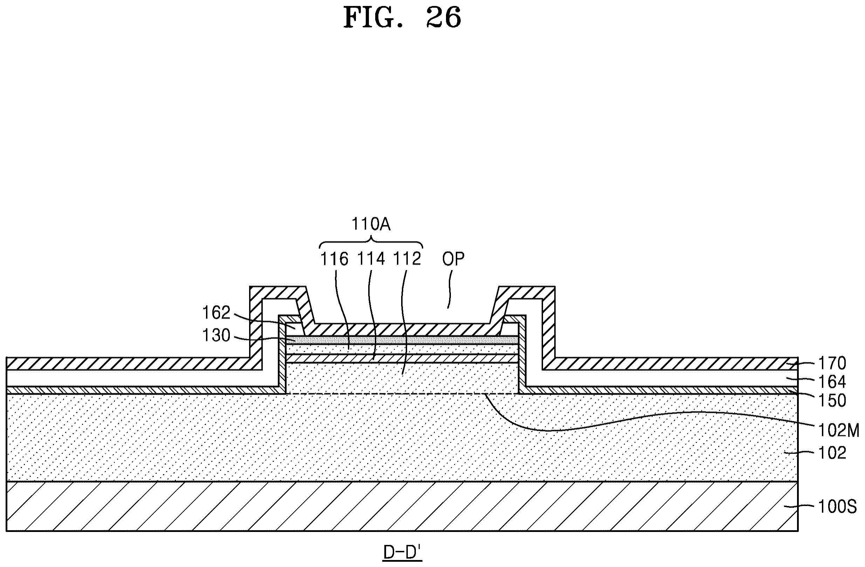

Referring to FIG. 26, after performing a process similar to the processes of FIGS. 12 and 13 on a resultant structure of FIG. 25, the reflective electrode layer 170 covering the opening OP exposing the transparent electrode layer 130 and the reflective structure 150 and the second lower insulating layer 164 surrounding the opening OP may be formed.

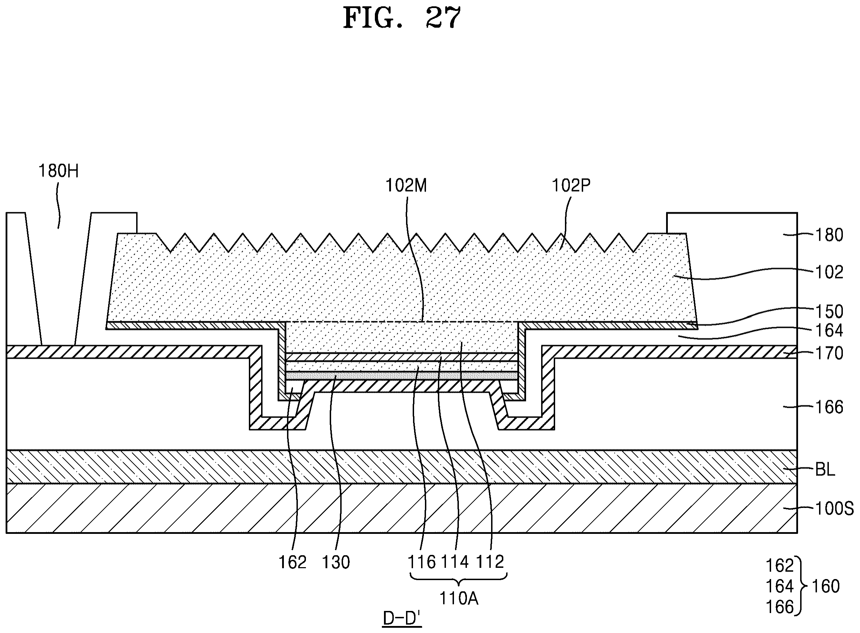

Referring to FIG. 27, after performing a process similar to the processes of FIGS. 15 to 17 on a resultant structure of FIG. 26, an outer portion of the first conductivity-type base layer 102 may be removed to expose the reflective electrode layer 170, and the upper insulating layer 180 may be formed to cover the exposed reflective electrode layer 170.

Next, the through-hole 180H that penetrates the upper insulating layer 180 and exposes the upper surface of the reflective electrode layer 170 may be formed.

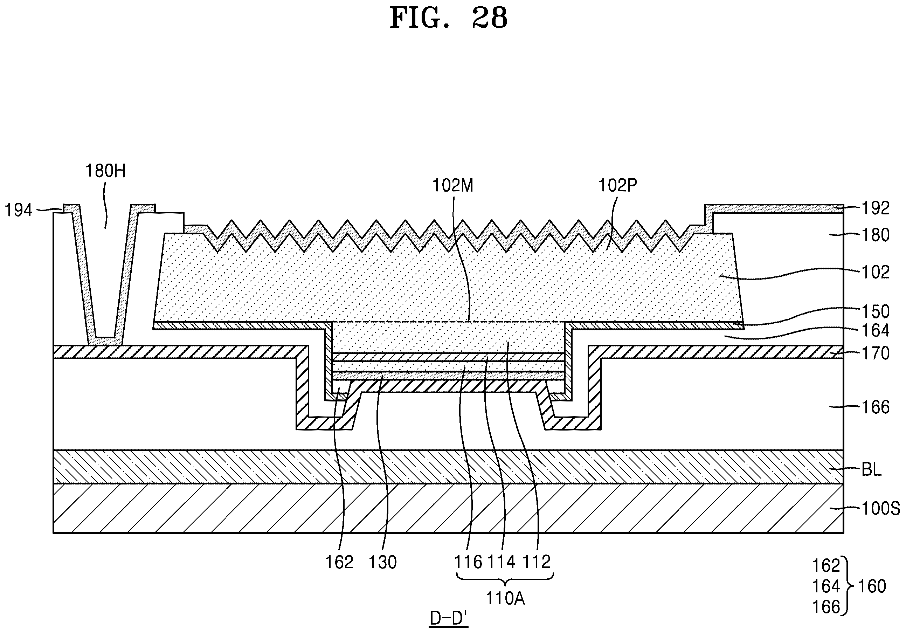

Referring to FIG. 28, a portion of the contact formation layer (not shown) may be etched by an etching process using a mask pattern as an etching mask in a resultant structure of FIG. 27 to form the first contact electrode 192 and the second contact electrode 194. Accordingly, the first contact electrode 192 and the second contact electrode 194 may include the same material.

The first contact electrode 192 may be formed to cover most of the upper surface of the first conductivity-type base layer 102 and a portion of the upper surface of the upper insulating layer 180. That is, the first contact electrode 192 may be conformally formed on the uneven surface 102P formed on the upper surface of the first conductivity-type base layer 102.

The second contact electrode 194 may be formed to cover a portion of the upper surface of the upper insulating layer 180 and the inner wall of the through-hole 180H. That is, the second contact electrode 194 may contact the upper surface of the reflective electrode layer 170 through the through-hole 180H.

Referring back to FIGS. 6 and 7, the adhesive layer BL and the carrier substrate 100S may be removed from a resultant structure of FIG. 28 to manufacture the light emitting device 30.

Referring to FIG. 29, the first conductivity-type base layer 102, the first conductivity-type semiconductor layer 112, the active layer 114, and the second conductivity-type semiconductor layer 116 are sequentially formed on the growth substrate 100, and the transparent electrode layer 130 and the first lower insulating layer 162 are formed on the second conductivity-type semiconductor layer 116.

Next, a portion of each of the first lower insulating layer 162, the transparent electrode layer 130, the second conductivity-type semiconductor layer 116, the active layer 114, and the first conductivity-type semiconductor layer 112 is etched by an etching process using the mask pattern as an etching mask, so that one light emitting structure 110A, one transparent electrode layer 130 covering one light emitting structure 110A, and one first lower insulating layer 162 may remain on the first conductivity-type base layer 102.

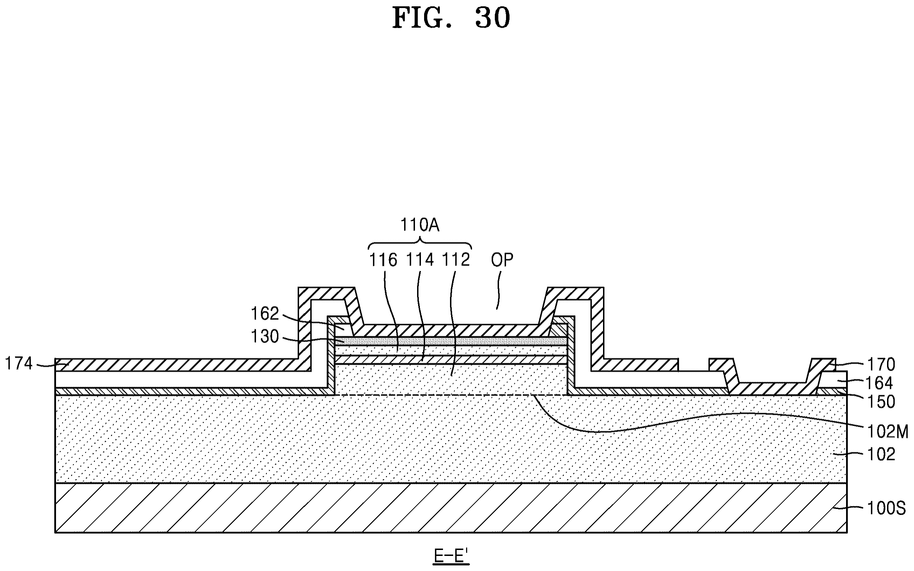

Referring to FIG. 30, after performing a process similar to the processes of FIGS. 12 and 13 on a resultant structure of FIG. 29, the first reflective electrode layer 172 in contact with a portion of the main surface 102M of the first conductivity-type base layer 102 and the second reflective electrode layer 174 covering the opening OP exposing the transparent electrode layer 130 and the reflective structure 150 and the second lower insulating layer 164 around the opening OP may be formed.

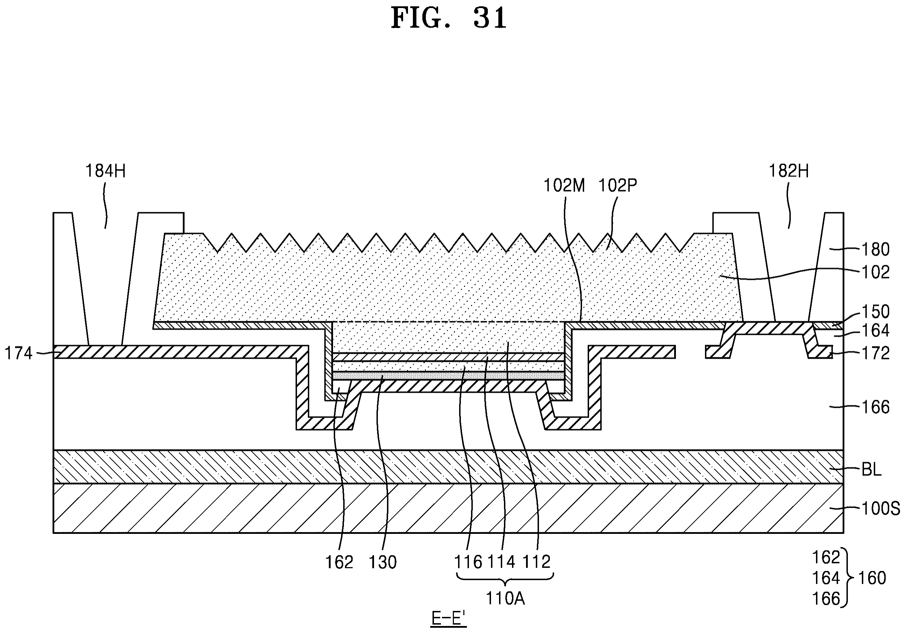

Referring to FIG. 31, after performing a process similar to the processes of FIGS. 15 to 17 on a resultant structure of FIG. 30, an outer portion of the first conductivity-type base layer 102 may be removed to expose the first reflective electrode layer 172 and the second reflective electrode layer 174, and the upper insulating layer 180 may be formed to cover the exposed first reflective electrode layer 172 and second reflective electrode layer 174.

Next, the first through-hole 182H that penetrates the upper insulating layer 180 and exposes the upper surface of the first reflective electrode layer 172 may be formed, and the second through-hole 184H that penetrates the upper insulating layer 180 and exposes the upper surface of the second reflective electrode layer 174 may be formed.

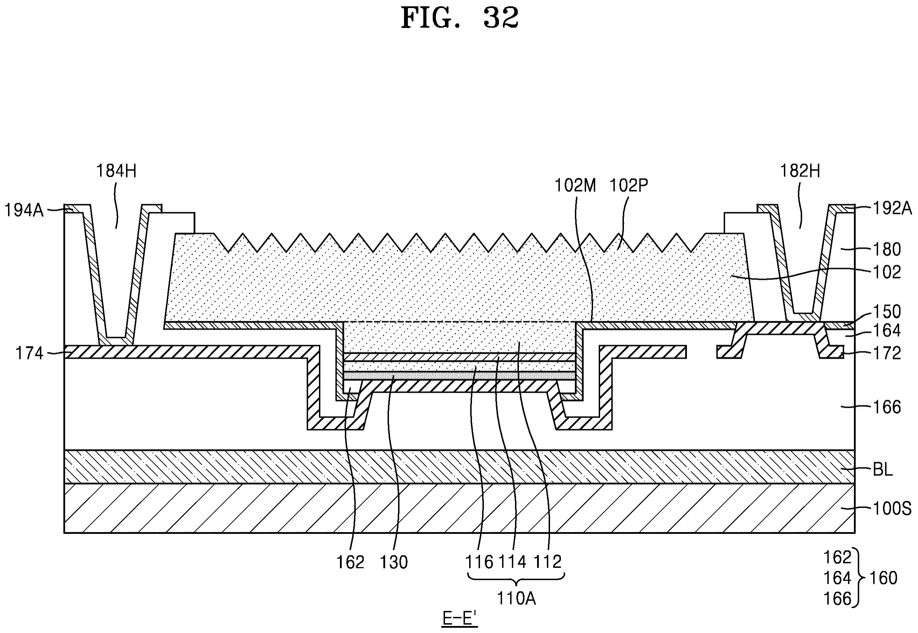

Referring to FIG. 32, a portion of the contact formation layer (not shown) may be etched by an etching process using a mask pattern as an etching mask in a resultant structure of FIG. 31 to form the first contact electrode 192A and the second contact electrode 194A separately. Accordingly, the first contact electrode 192A and the second contact electrode 194A may include the same material.

The first contact electrode 192A may be formed to cover the inner wall of the first through-hole 182H and the upper surface of the first reflective electrode layer 172. The second contact electrode 194A may be formed to cover the inner wall of the second through-hole 184H and the upper surface of the second reflective electrode layer 174.

Referring back to FIGS. 8 and 9, the adhesive layer BL and the carrier substrate 100S may be removed from a resultant structure of FIG. 32 to manufacture the light emitting device 40.

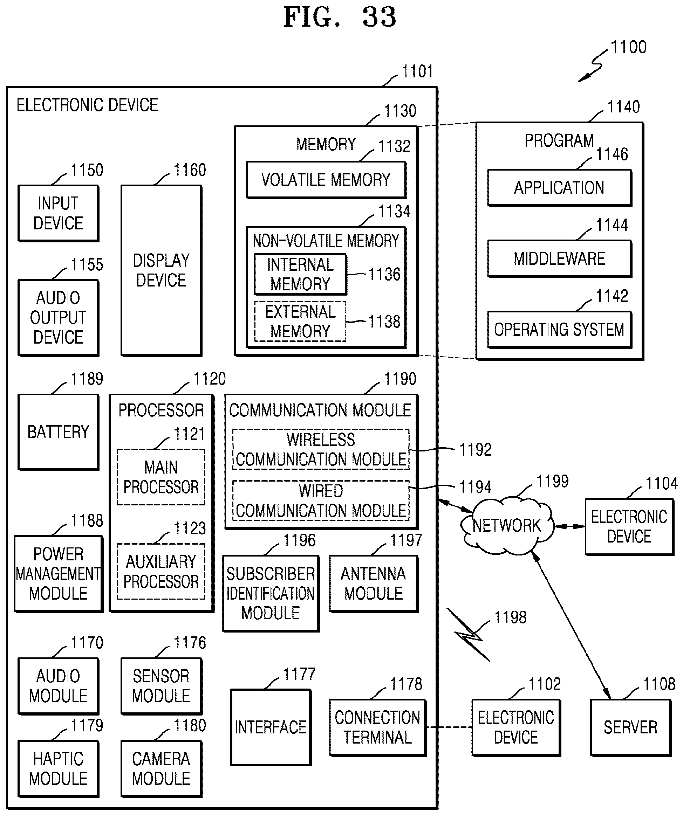

FIG. 33 is a block diagram of an electronic device 1101 including a light emitting device or a display apparatus according to an embodiment.

Referring to FIG. 33, the electronic device 1101 may be provided within a network environment 1100.

In a network environment 1100, the electronic device 1101 may communicate with another electronic device 1102 via a first network 1198 (such as a short-range wireless communication network, etc.) or may communicate with another electronic device 1104 and/or a server 1108 via a second network 1199 (such as a long-range wireless communication network). The electronic device 1101 may communicate with the electronic device 1104 via the server 1108.

The electronic device 1101 may include a processor 1120, a memory 1130, an input device 1150, an audio output device 1155, a display device 1160, an audio module 1170, a sensor module 1176, an interface 1177, a haptic module 1179, a camera module 1180, a power management module 1188, a battery 1189, a communication module 1190, a subscriber identification module 1196, and/or an antenna module 1197. In the electronic device 1101, some of these components may be omitted or other components may be added. Some of these components may be implemented as a single integrated circuit. For example, the sensor module 1176 (such as a fingerprint sensor, an iris sensor, or a light sensor) may be embedded in the display device 1160 (such as a display) to be implemented.

The processor 1120 may execute software (such as a program 1140) to control one or a plurality of other components (such as hardware, software components, etc.) of the electronic device 1101 connected to the processor 1120 and perform various data processing or operations. As part of data processing or arithmetic operation, the processor 1120 may load commands and/or data received from other components (such as the sensor module 1176, the communication module 1190, etc.) to a volatile memory 1132, process the commands and/or data stored in the volatile memory 1132, and store resulting data in a non-volatile memory 1134. The processor 1120 may include a main processor 1121 (central processing unit, application processor, etc.) and an auxiliary processor 1123 (graphics processing unit, image signal processor, sensor hub processor, communication processor, etc.) that may operate independently or together with the main processor 1121. The auxiliary processor 1123 may use less power than the main processor 1121 and may perform specialized functions.

The auxiliary processor 1123 may control functions and/or states related to some (such as the display device 1160, the sensor module 1176, and the communication module 1190) of the components of the electronic device 1101 on behalf of the main processor 1121 while the main processor 1121 is in an inactive state (a sleep state) or together with the main processor 1121 while the main processor 1121 is in an active state (an application execution state). The auxiliary processor 1123 (an image signal processor, a communication processor, etc.) may also be implemented as part of other functionally related components (the camera module 1180, the communication module 1190, etc.).

The memory 1130 may store various data required by components (the processor 1120, the sensor module 1176, etc.) of the electronic device 1101. The data may include, for example, input data and/or output data for software (such as the program 1140) and instructions associated with the software. The memory 1130 may include the volatile memory 1132 and/or the non-volatile memory 1134.

The program 1140 may be stored as software in the memory 1130 and may include an operating system 1142, middleware 1144 and/or an application 1146.

The input device 1150 may receive commands and/or data to be used in components (such as the processor 1120) of the electronic device 1101 from an external source (such as a user) of the electronic device 1101. The input device 1150 may include a remote controller, a microphone, a mouse, a keyboard, and/or a digital pen (such as a stylus pen).

The audio output device 1155 may output an audio signal to the outside of the electronic device 1101. The audio output device 1155 may include a speaker and/or a receiver. The speaker may be used for general purposes, such as playing multimedia or recording, and the receiver may be used to receive an incoming call. The receiver may be integrated as part of the speaker or implemented as a separate, independent device.

The display device 1160 may visually provide information to the outside of the electronic device 1101. The display device 1160 may include a display, a holographic device, or a projector and a control circuit for controlling the corresponding device. The display device 1160 may include the light emitting device 10, 20, 30, or 40 described above with reference to FIGS. 1-9 or the display apparatus 1000 described above with reference to FIG. 10. The display device 1160 may include a touch circuit configured to detect a touch, and/or a sensor circuit (such as a pressure sensor, etc.) configured to measure the intensity of a force generated by a touch.

The audio module 1170 may convert sound into an electrical signal, or vice versa, convert an electrical signal into sound. The audio module 1170 may acquire sound through the input device 1150, or output sound through the audio output device 1155 and/or a speaker and/or headphone of another electronic device (such as an electronic device 1102) directly or wirelessly connected to the electronic device 1101.

The sensor module 1176 may detect an operating status (power, temperature, etc.) of the electronic device 1101 or an external environmental state (a user state, etc.) and generate an electrical signal and/or data corresponding to the detected state. The sensor module 1176 may include a gesture sensor, a gyro sensor, a barometric pressure sensor, a magnetic sensor, an acceleration sensor, a grip sensor, a proximity sensor, a color sensor, an infrared (IR) sensor, a biometric sensor, a temperature sensor, a humidity sensor, and/or illumination sensor.

The interface 1177 may support one or more designated protocols that may be used for the electronic device 1101 to be connected directly or wirelessly to another electronic device (such as the electronic device 1102). The interface 1177 may include a high-definition multimedia interface (HDMI), a universal serial bus (USB) interface, an SD card interface, and/or an audio interface.

A connection terminal 1178 may include a connector for the electronic device 1101 to be physically connected to another electronic device (such as the electronic device 1102). The connection terminal 1178 may include an HDMI connector, a USB connector, an SD card connector, and/or an audio connector (such as a headphone connector).

The haptic module 1179 may convert electrical signals into mechanical stimuli (vibration, movement, etc.) or electrical stimuli that a user may perceive through tactile or kinesthetic sensations. The haptic module 1179 may include a motor, a piezoelectric element, and/or an electrical stimulation device.

The camera module 1180 may capture still images and videos. The camera module 1180 may include a lens assembly including one or more lenses, image sensors, image signal processors, and/or flashes. A lens assembly included in the camera module 1180 may collect light emitted from a subject that is a target of image capture.

The power management module 1188 may manage power supplied to the electronic device 1101. The power management module 1188 may be implemented as part of a power management integrated circuit (PMIC).

The battery 1189 may power components of the electronic device 1101. The battery 1189 may include a non-rechargeable primary battery, a rechargeable secondary battery, and/or a fuel cell.

The communication module 1190 may support establishment of a direct (wired) communication channel and/or a wireless communication channel between the electronic device 1101 and another electronic device (the electronic device 1102, the electronic device 1104, the server 1108, etc.), and performance of communication through the established communication channel. The communication module 1190 may include one or more communication processors that are operated independently from the processor 1120 (such as an application processor) and support direct communication and/or wireless communication. The communication module 1190 may include a wireless communication module 1192 (a cellular communication module, a short-range wireless communication module, a global navigation satellite system (GNSS) communication module) and/or a wired communication module 1194 (a local area network (LAN) communication module, a power line communication module, etc.). Any of these communication modules may communicate with other electronic devices via the first network 1198 (a short-range communication network, such as Bluetooth, WiFi Direct, or Infrared Data Association (IrDA)) or the second network 1199 (a long-range communication network, such as a cellular network, the Internet, or a computer network (LAN, WAN, etc.)). These different types of communication modules may be integrated into a single component (such as a single chip) or implemented as a plurality of separate components (a plurality of chips). The wireless communication module 1192 may verify and authenticate the electronic device 1101 within a communication network, such as the first network 1198 and/or the second network 1199, using subscriber information (such as international mobile subscriber identity (IMSI)) stored in the subscriber identification module 1196.

The antenna module 1197 may transmit or receive signals and/or power to or from an external source (such as another electronic device). The antenna module 1197 may include a radiator including a conductive pattern on a substrate (such as a PCB). The antenna module 1197 may include one or more antennas. When multiple antennas are included, an antenna suitable for a communication method used in a communication network, such as the first network 1198 and/or the second network 1199, may be selected from the multiple antennas by the communication module 1190. Signals and/or power may be transmitted or received between the communication module 1190 and other electronic devices via the selected antenna. In addition to the antenna, other components (such as an RFIC) may be included as part of the antenna module 1197.

Some of the components of the electronic device 1101 may be connected to each other and exchange signals (commands, data, etc.) through communication methods between peripheral devices (bus, general purpose input and output (GPIO), serial peripheral interface (SPI), mobile industry processor interface (MIPI), etc.).

Commands or data may be transmitted or received between the electronic device 1101 and the external electronic device 1104 via the server 1108 connected to the second network 1199. The other electronic devices 1102 and 1104 may be the same or different types of devices as the electronic device 1101. All or part of operations executed in the electronic device 1101 may be executed in one or more of the other electronic devices 1102, 1104, and 1108. For example, when the electronic device 1101 needs to perform a function or service, instead of executing the function or service on its own, the electronic device 1101 may request one or more other electronic devices to perform part or all of the function or service. One or more other electronic devices that receive the request may execute additional functions or services related to the request and transmit the results of the execution to the electronic device 1101. To this end, cloud computing, distributed computing, and/or client-server computing technologies may be used.

The electronic device 1101 may be applied to various devices. Depending on the function of the device, various components of the electronic device 1101 may be appropriately modified, and components appropriate for performing the function of the device may be added. Hereinafter, applications of the electronic device 1101 are described.

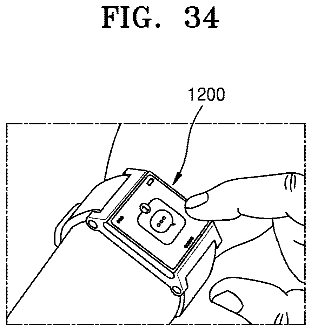

FIG. 34 is a diagram illustrating a wearable device as an electronic device including a light emitting device or a display apparatus according to an embodiment.

Referring to FIG. 34, a wearable display 1200 may include the light emitting device 10, 20, 30, or 40 described above with reference to FIGS. 1-9 or the display apparatus 1000 described above with reference to FIG. 10. The wearable display 1200 may be, for example, a smart watch worn on the wrist. The wearable display 1200 may be implemented through the electronic device described above with reference to FIG. 33.

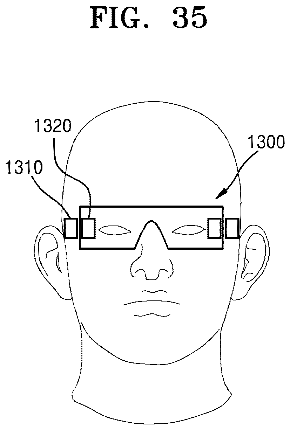

FIG. 35 is a diagram illustrating augmented reality glasses 1300 as an electronic device including a light emitting device or a display apparatus according to an embodiment.

Referring to FIG. 35, the augmented reality glasses (or virtual reality glasses) 1300 may include a projection system 1310 that forms an image and an element 1320 that guides the image from the projection system 1310 into the user' s eyes. The projection system 1310 may include the light emitting device 10, 20, 30, or 40 with reference to FIGS. 1-9 described above or the display apparatus 1000 described above with reference to FIG. 10.

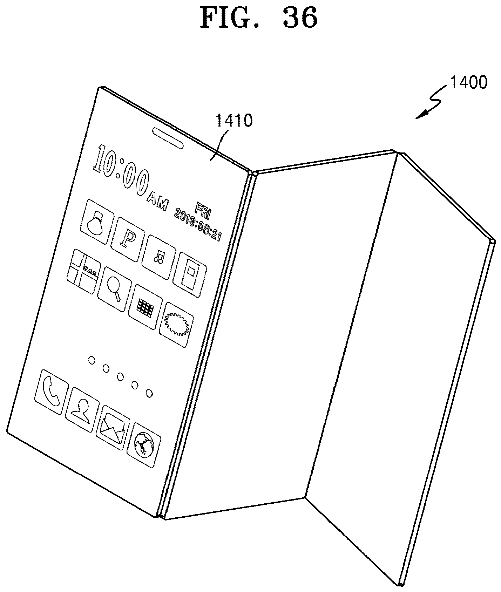

FIG. 36 is a diagram illustrating a mobile device 1400 as an electronic device including a light emitting device or a display apparatus according to an embodiment.

Referring to FIG. 36, the mobile device 1400 may include a display apparatus 1410. The display apparatus 1410 may include the light emitting device 10, 20, 30, or 40 described above with reference to FIGS. 1-9 or the display apparatus 1000 described above with reference to FIG. 10. The display apparatus 1410 may have a foldable structure, for example, a multi-foldable structure.

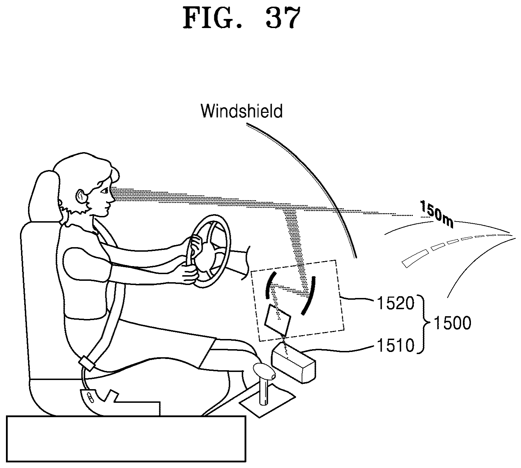

FIG. 37 is a diagram illustrating a head-up display device 1500 as an electronic device including a light emitting device or display apparatus according to an embodiment.

Referring to FIG. 37, the head-up display device 1500 for an automobile may include a display 1510 provided in a region of the automobile and an optical path changing member 1520 that changes an optical path so that a driver may view an image generated in the display 1510. The display 1510 may include the light emitting device 10, 20, 30, or 40 described above with reference to FIGS. 1-9 or the display apparatus 1000 described above with reference to FIG. 10.

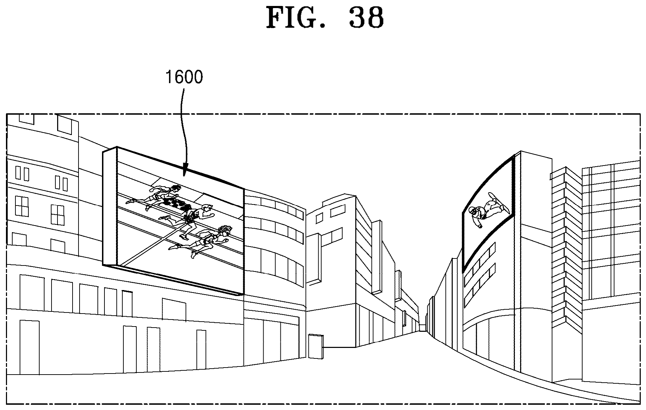

FIG. 38 is a diagram illustrating a large signage 1600 as an electronic device including a light emitting device or display apparatus according to an embodiment.

Referring to FIG. 38, the signage 1600 may include the light emitting device 10, 20, 30, or 40 described above with reference to FIGS. 1-9 or the display apparatus 1000 described above with reference to FIG. 10. The signage 1600 may be used for outdoor advertising using digital information display and may control advertising contents, etc. through a communication network. The signage 1600 may be implemented, for example, through the electronic device described above with reference to FIG. 33.

In some embodiments, the light emitting device 10, 20, 30, or 40 described above with reference to FIGS. 1-9 or the display apparatus 1000 described above with reference to FIG. 10 may be applied to various products, such as a rollable TV and a stretchable display in addition to the electronic devices described above.

While various embodiments have been particularly shown and described with reference the drawings, it will be understood that various changes in form and details may be made therein without departing from the scope of the following claims.

## Claims

1. A light emitting device (10) comprising:
a light emitting structure (110) including a first conductivity-type semiconductor layer (112), an active layer (114), and a second conductivity-type semiconductor layer (116) in a vertical direction from top to bottom;
a first conductivity-type base layer (102) located on the light emitting structure (110);
a transparent electrode layer (130) below the second conductivity-type semiconductor layer (116) and covering the second conductivity-type semiconductor layer (116);
a reflective electrode layer (170) contacting the transparent electrode layer (130) and extending in a horizontal direction;
an upper insulating layer (180) surrounding the first conductivity-type base layer (102);
a first contact electrode (192) conformally disposed on an upper surface of the first conductivity-type base layer (102); and
a second contact electrode (194) penetrating the upper insulating layer (180) and contacting the reflective electrode layer (170),
wherein a vertical level of each of uppermost surfaces of the first contact electrode (192) and the second contact electrode (194) is higher in the vertical direction than a vertical level of an uppermost surface of the first conductivity-type base layer (102) in the vertical direction, and
wherein a vertical level of a lowermost surface of the second contact electrode (194) in the vertical direction is lower than a vertical level of a lowermost surface of the first conductivity-type base layer (102) in the vertical direction.

2. The light emitting device (10) of claim 1, wherein:
a through-hole (180H) is formed to expose an upper surface of the reflective electrode layer (170) through the upper insulating layer (180), and
the second contact electrode (194) is conformally formed on an inner wall of the through-hole (180H).

3. The light emitting device (10) of claim 1 or 2, wherein the first contact electrode (192) includes a portion that extends along the upper surface of the first conductivity-type base layer (102) and an upper surface of the upper insulating layer (180).

4. The light emitting device (10) of any preceding claim, wherein each of the first contact electrode (192) and the second contact electrode (194) comprises a transparent electrode.

5. The light emitting device (10) of any preceding claim, wherein a horizontal width of the first conductivity-type base layer (102) is greater than a horizontal width of the light emitting structure (110).

6. The light emitting device (10) of any preceding claim, wherein:
the upper surface of the first conductivity-type base layer (102) has an uneven structure (102P),
a portion of the uneven structure (102P) includes a recess (102R) having a certain depth and a flat bottom surface, and
the first contact electrode (192) is conformally formed on the uneven structure (102P) and the recess (102R).

7. The light emitting device (10) of any preceding claim, wherein:
the light emitting structure (110) is provided in plurality, and the plurality of light emitting structures (110R, 110G, 110B) emit light having different wavelengths,
the second contact electrode (194) is provided in plurality, and the plurality of second contact electrodes (194R, 194G, 194B) correspond to the plurality of light emitting structures (110R, 110G, 110B), respectively, and
the first contact electrode (192) is a common electrode corresponding to all of the plurality of light emitting structures (110R, 110G, 110B).

8. The light emitting device (10) of claim 7, wherein:
in a plan view, the first contact electrode (192) covers all of the plurality of light emitting structures (110R, 110G, 110B), and
the plurality of second contact electrodes (194R, 194G, 194B) are apart from the plurality of light emitting structures (110R, 110G, 110B) to face at least one side surface of the plurality of light emitting structures (110R, 110G, 110B), respectively.

9. The light emitting device (30) of any of claims 1 to 6, wherein:
the light emitting structure (110) is provided as a single light emitting structure (110A) that emits light having one wavelength, and
the first contact electrode (192) and the second contact electrode (194) are respectively provided as a single first contact electrode and a single second contact electrode to correspond to the single light emitting structure (110A).

10. The light emitting device (30) of claim 9, wherein:
in a plan view, the first contact electrode (192) covers all of the single light emitting structure (110A), and
the second contact electrode (194) is spaced apart from the single light emitting structure (110A) to face at least one side surface of the single light emitting structure (110A).

11. A light emitting device (20) comprising:
a light emitting structure (110) including a first conductivity-type semiconductor layer (112), an active layer (114), and a second conductivity-type semiconductor layer (116) in a vertical direction from top to bottom;
a first conductivity-type base layer (102) on the light emitting structure (110);
a transparent electrode layer (130) below the second conductivity-type semiconductor layer (116) and covering the second conductivity-type semiconductor layer (116);
a first reflective electrode layer (172) contacting a lower surface of the first conductivity-type base layer (102) and extending in a horizontal direction;
a second reflective electrode layer (174) contacting a lower surface of the transparent electrode layer (130) and extending in the horizontal direction;
an upper insulating layer (180) surrounding the first conductivity-type base layer (102);
a first contact electrode (192A) penetrating the upper insulating layer (180) and contacting the first reflective electrode layer (172); and
a second contact electrode (194A) penetrating the upper insulating layer (180) and contacting the second reflective electrode layer (174),
wherein a vertical level of each of uppermost surfaces of the first contact electrode (192A) and the second contact electrode (194A) in the vertical direction is higher than a vertical level of an uppermost surface of the first conductivity-type base layer (102) in the vertical direction, and
wherein a vertical level of each of lowermost surfaces of the first contact electrode (192A) and the second contact electrode (194A) in the vertical direction is equal to or lower than a vertical level of a lowermost surface of the first conductivity-type base layer (102) in the vertical direction.

12. The light emitting device (20) of claim 11, wherein a vertical level of an uppermost surface of the first reflective electrode layer (172) in the vertical direction is higher than a vertical level of an uppermost surface of the second reflective electrode layer (174).

13. The light emitting device (20) of claim 11 or 12, further comprising:
a first through-hole (182H) that penetrates the upper insulating layer (180) and exposes an upper surface of the first reflective electrode layer (172);
a second through-hole (184H) that penetrates the upper insulating layer (180) and exposes an upper surface of the second reflective electrode layer (174),
wherein the first contact electrode (192A) is conformally formed on an inner wall of the first through-hole (182H), and the second contact electrode (194A) is conformally formed on an inner wall of the second through-hole (184H).

14. The light emitting device (20) of claim 11, wherein the vertical level of the uppermost surface of the first contact electrode (192A) is the same as the vertical level of the uppermost surface of the second contact electrode (194A).

15. The light emitting device (20) of any of claims 11 to 14, wherein the first contact electrode (192A) and the second contact electrode (194A) each comprise a reflective electrode.
